# EUROPEAN PATENT APPLICATION

(11) **EP 2 910 952 A1**
(43) Date of publication of application: **26.08.2015**
(21) Application number: 12886642.3
(22) Date of filing: 16.10.2012
(51) Int. Cl.: G01P 15/125, G01P 21/00

(54) **INERTIAL SENSOR**

(71) Applicant: Hitachi Automotive Systems, Ltd., Hitachinaka-shi, Ibaraki 312-8503 (JP)
(72) Inventor: YAMANAKA, Kiyoko, Chiyoda-ku Tokyo 100-8280 (JP); JEONG, Heewon, Chiyoda-ku Tokyo 100-8280 (JP); HAYASHI, Masahide, Hitachinaka-shi Ibaraki 312-8503 (JP)
(74) Representative: MERH-IP Matias Erny Reichl Hoffmann
(86) International application number: PCT/JP2012/076691
(87) International publication number: WO 2014/061099

(57) **Abstract**

A technique of preventing the function stop caused by false operation and false output of an inertial sensor by canceling a signal caused by applying of an acceleration other than a measurement signal before input to an LSI circuit is provided. An electrostatic-capacitance MEMS acceleration sensor 100 is configured to include: a movable unit 104; a P-side first electrode pair formed of a detection movable electrode 105a and a detection fixed electrode 106a; a P-side second electrode pair formed of a detection movable electrode 105b and a detection fixed electrode 106b; an N-side first electrode pair formed of a detection movable electrode 109a and a detection fixed electrode 110a; and an N-side second electrode pair formed of a detection movable electrode 109b and a detection fixed electrode 110b, the movable unit 104 is supported at one point of a fixed portion 101 arranged on an inner side of the movable unit 104, and besides, the fixed portion 101 of the movable unit 104, a fixed portion 107 of the detection fixed electrode 106a, a fixed portion 108 of the detection fixed electrode 106b, a fixed portion 111 of the detection fixed electrode 110a, and a fixed portion 112 of the detection fixed electrode 110b are arranged on a line 116 perpendicular to a detection direction 115 of the MEMS acceleration sensor 100, and besides, the P-side first electrode pair and the N-side first electrode pair are arranged on one side of the fixed portion 101 of the movable unit 104, and the P-side second electrode pair and the N-side second electrode pair are arranged on the other side thereof.

## Description

### TECHNICAL FIELD

The present invention relates to an inertial sensor. More specifically, the present invention relates to a technique effectively applied to an inertial sensor for detecting physical quantity having one detection axis caused by an inertia force acting on an object.

### BACKGROUND ART

A background technique of the present technical field includes Japanese Patent Application Laid-open Publication (Translation of PCT Application) No. 2010-513888 (Patent Document 1). The Patent Document 1 describes a structure of an acceleration sensor which includes a movable unit (elastic wave mass body) that displaces in one axial direction, a movable electrode connected to the movable unit, and a comb-teeth-shaped electrode configured from a fixed electrode connected to a substrate, and in which all fixed regions are arranged at a central region of the substrate. In this acceleration sensor structure, the movable electrode connected to the movable unit and the comb-teeth-shaped electrode configured from the fixed electrode connected to the substrate are arranged in parallel to the displacement direction of the movable unit, and the comb-teeth-shaped electrode configures a capacitor in an overlap region.

### PRIOR ART DOCUMENT

### PATENT DOCUMENT

Patent Document 1: Japanese Patent Application Laid-Open Publication (Translation of PCT Application) No. 2010-513888

### SUMMARY OF THE INVENTION

### PROBLEMS TO BE SOLVED BY THE INVENTION

A generally and widely used MEMS inertial sensor (also referred to as sensor module) includes a mechanical element configured by a proof mass (movable unit) and a beam (elastic deformation unit) that supports the proof mass. According to an acceleration sensor device, a displacement amount of the proof mass supported with the beam which is displaceable in one axial direction, displaced by the acceleration applied on the substrate with respect to the substrate (also referred to as MEMS element) having the mechanical element of the MEMS inertial sensor formed thereon, is converted to an electric signal with an LSI circuit.

In the acceleration sensor device, the displacement amount of the proof mass can be detected as a capacity variation value of the capacitor formed by the movable electrode connected to the proof mass and the fixed electrode connected to the substrate. When it is assumed that an opposing area of the capacitor is "S", that a distance between electrodes forming the capacitor is "d", and that a dielectric constant of a substance filled between the electrodes forming the capacitor is "ε", the capacitance of the capacitor of when the acceleration is not applied thereon is expressed as "C = εS/d".

In a parallel plate type capacitor, when it is assumed that the displacement amount of the proof mass in the direction of reducing the inter-electrode distance of the capacitor by applying the application is "Δd", if the displacement amount Δd of the proof mass by the applied acceleration is sufficiently smaller than the inter-electrode distance d, the capacitance variation of the capacitor by the applied acceleration is expressed as "ΔC/C ≈ Δd/d". That is, the variation of the capacitance value of the capacitor is proportional to the acceleration applied on the MEMS inertial sensor. The variation of the capacitance value of the capacitor is converted to the electric signal with the LSI circuit, and then, is outputted.

However, the capacitance value of the capacitor varies even in a case other than the displacement of the proof mass by the applied acceleration in some cases. An example of such a case will be described below as <Cause of offset variation > and <Demerit of offset variation>.

### <Cause of offset variation>

The substrate having the mechanical element of the MEMS inertial sensor formed thereon is fixed to a package with an adhesive together with the substrate of the LSI circuit. The package in this case is obtained by a previously-molded shape made of a ceramics material. The inertial sensor is normally used in a temperature range of -45°C to 125°C for, for example, in-vehicle applications without being maintained at a constant temperature. The substrate having the mechanical element of the MEMS inertial sensor formed thereon is different from the adhesive and the package material in the thermal expansion coefficient. Therefore, when the temperature of the environment where the package of the MEMS inertial sensor is placed varies, deformation of the substrate having the mechanical element of the MEMS inertial sensor formed thereon occurs. By the deformation a relative distance between the movable electrode connected to the proof mass and the fixed electrode connected to the substrate is varied. That is, even if the acceleration is not applied, when the temperature of the environment where the inertial sensor is placed varies, the capacitance value of the capacitor varies, and the output of the inertial sensor comes out. This is called a zero point offset, and the zero point offset caused by the temperature variation is desirably small in the acceleration sensor.

In recent years, in order to reduce the cost caused when the MEMS inertial sensor is packaged, a manufacturing process using a transfer mold step is given attention. The transfer mold step is the following manufacturing process. First, the substrate formed with the MEMS inertial sensor, the LSI circuit and a lead frame are placed in a die, and then, a warmed resin is injected at high pressure to fill it in the die. When the resin is cooled and solidified, a mold resin package in which the substrate formed with the MEMS inertial sensor, the LSI circuit, and the lead frame are fixed is obtained. The transfer mold step is an effective process in terms of reducing the manufacturing cost of the inertial sensor since the mass productivity is higher than that of the conventional ceramic package step.

However, the resin which is the component material has such features as expansion of the volume by moisture absorption and shrinkage of the volume by drying. When the humidity of the environment where the package is placed varies, the deformation of the substrate formed with the MEMS inertial sensor placed inside is caused by the expansion and the shrinkage of the package component material. By this deformation the relative distance between the movable electrode connected to the proof mass and the fixed electrode connected to the substrate is varied That is, even if the acceleration is not applied, when the humidity of the environment where the inertial sensor is placed varies, the capacitance value of the capacitor varies, the output of the inertial sensor comes out, and the zero point offset occurs.

### <Demerit of offset variation>

The occurrence of the zero point offset by the temperature variation and the occurrence of the zero point offset by the humidity variation can be corrected with the LSI circuit. However, if a temperature sensor and a humidity sensor are mounted on the LSI circuit, the chip area is increased by the mounted area, the material cost is increased, and the manufacturing cost of the LSI circuit is increased. Furthermore, if a correction computation circuit is added which results in complication of the function, a period for developing the LSI circuit becomes longer, and the manufacturing cost becomes higher. Moreover, if a correction adjustment step is added at the time of pre-shipment inspection of the inertial sensor in order to establish the correction computation, the adjustment cost and the adjustment time increase, and there is such a demerit as the high manufacturing cost of the inertial sensor.

For such a problem, for example, a prior technique described in the Patent Document 1 has been proposed. In the technique of the Patent Document 1, if the movable unit is displaced in one axial direction by applying the acceleration, the overlap length of the capacitor configured by the comb-teeth-shaped electrode varies, and the capacitance value of the capacitor varies, and thus, the acceleration applied to the movable unit can be known by measuring the capacitance variation value. In the Patent Document 1, by arranging all the fixed regions at the central region of the substrate, a high insensitiveness can be obtained for the substrate curvature and similar deformation. That is, the offset variation can be suppressed.

However, as a result studied on the prior technique of the above-described Patent Document 1 by the inventors, the following has been found out. The following is explanation for <Problem> and <Reason>.

### <Problem>

The acceleration sensor structure described in the above-described Patent Document 1 has such a possibility that the noise output cannot be suppressed if the acceleration is applied in a direction other than the acceleration detection axis which is desired to be essentially measured. Particularly, if such a rotary acceleration as having a rotation axis in the perpendicular direction is applied to the substrate formed with the movable unit of the acceleration sensor, it has such a possibility that the noise output cannot be significantly suppressed.

### <Reason>

Since the movable unit is a mechanical element, this is displaced in some cases even if the acceleration other than the measurement signals such as a rotary acceleration having a rotation axis in the perpendicular direction is applied When the rotary acceleration having the rotation axis in the perpendicular direction is inputted and displaced, the overlap lengths of the capacitors configured by all the comb-teeth-shaped electrodes increase all together or decrease all together. That is, the capacitance values of the capacitors configured by all the comb-teeth-shaped electrodes increase all together or decrease all together. That is, total of the capacitance values of the capacitors each configured by the individual com-teeth-shaped electrode increases all together or decreases all together regardless of the capacitor on the right side of the fixed region of the movable unit or the capacitor on the left side of the fixed region of the movable unit. Such variation is also converted to the electric signal by the LSI circuit, and therefore, the electric signal becomes a noise in some cases, which results in decrease in the accuracy of the inertial sensor.

If the electric signal exceeds a range in which this electric signal can be handled by the LSI circuit, that is, if the LSI circuit causes saturation, the electric signal causes function stop of the inertial sensor due to burying of the signal to be essentially measured in the saturated signal in some cases.

Therefore, in order to suppress such a function stop by the false operation and the false output of the inertial sensor due to the applied acceleration other than the measurement signal, the signal caused by the applied acceleration other than the measurement signal is to be canceled out before the input to the LSI circuit.

Accordingly, the present invention has been made in consideration of such problems, and a typical object of the present invention is to provide a technique of suppressing the function stop caused by the false operation and the false output of the inertia sensor by canceling out the signal caused by the applied acceleration other than the measurement signal before the input to the LSI circuit.

The above and other object and novel characteristics of the present invention will be apparent from the description of the present specification and the accompanying drawings.

### MEANS FOR SOLVING THE PROBLEMS

The typical summary of the inventions disclosed in the present application will be briefly described as follows.

In other words, the typical inertial sensor is an electrostatic-capacitance inertial sensor having the following feature. The inertial sensor includes: a movable unit, a positive direction first electrode pair whose capacitance value is increased by a positive direction displacement of a detection axis of the movable unit; a positive direction second electrode pair whose capacitance value is increased by a positive direction displacement of the detection axis of the movable unit; a negative direction first electrode pair whose capacitance value decreases with respect to a negative direction displacement of the detection axis of the movable unit; and a negative direction second electrode pair whose capacitance value decreases with respect to a negative direction displacement of the detection axis of the movable unit.

The movable unit is supported at one point of a fixed portion provided inside the movable unit. Furthermore, a fixed portion of the movable unit, a fixed portion of the positive direction first electrode pair, a fixed portion of the positive direction second electrode pair, a fixed portion of the negative direction first electrode pair, and a fixed portion of the negative direction second electrode pair are arranged on a line perpendicular to a detection direction of the inertial sensor. Moreover, the present invention has such a feature that the positive direction first electrode pair and the negative direction first electrode pair are arranged on one side of the fixed portion of the movable unit, and the positive direction second electrode pair and the negative direction second electrode pair are arranged on the other side thereof

### EFFECTS OF THE INVENTION

The effects obtained by typical aspects of the present invention will be briefly described below.

In other words, in the typical effects, the function stop by the false operation and the false output of the inertial sensor can be suppressed by cancelling out the signal caused by the applied acceleration other than the measurement signal before the input to the LSI circuit.

### BRIEF DESCRIPTIONS OF THE DRAWINGS

FIG 1 is a plan view showing one example of a planar configuration of a MEMS acceleration sensor according to a first embodiment of the present invention;
FIG 2 is a circuit diagram of one example of a circuit configuration of the MEMS acceleration sensor according to the first embodiment of the present invention;
FIG 3 is an explanatory diagram showing one example of signal increase/decrease in each electrode when acceleration and rotary noise are inputted to the MEMS acceleration sensor according to the first embodiment of the present invention;
FIGs. 4(a) and 4(b) are cross-sectional views showing one example of a cross-sectional configuration obtained when the substrate is not deformed in the MEMS acceleration sensor according to the first embodiment of the present invention;
FIGs. 5(a) and 5(b) are cross-sectional views showing one example of a cross-sectional configuration obtained when the substrate is not deformed in the MEMS acceleration sensor according to the first embodiment of the present invention;
FIG 6 is a plan view showing one example of a planar configuration of a MEMS acceleration sensor according to conventional technique;
FIGs. 7(a) and 7(b) are cross-sectional views showing one example of a cross-sectional configuration obtained when the substrate is not deformed in the MEMS acceleration sensor according to the conventional technique;
FIGs. 8(a) and 8(b) are cross-sectional views showing one example of a cross-sectional configuration obtained when the substrate is not deformed in the MEMS acceleration sensor according to the conventional technique;
FIGs. 9(a) and 9(b) are graphs showing one example of the variation amount of the inter-electrode distance with respect to the nonlinear substrate deformation in the detection axis direction in the comparison between the MEMS acceleration sensor according to the first embodiment of the present invention and the MEMS acceleration sensor according to the conventional technique, and one example of an analyzing result of the converted offset variation amount;
FIG 10 is a cross-sectional view showing one example of a cross-sectional configuration of a sensor chip of the MEMS acceleration sensor according to the first embodiment of the present invention;
FIG 11 is a cross-sectional view showing one example of a cross-sectional configuration of a package of the MEMS acceleration sensor according to the first embodiment of the present invention;
FIG 12 is a plan view showing one example of a planar configuration of a MEMS acceleration sensor according to a second embodiment of the present invention; and
FIG 13 is a plan view showing one example of a planar configuration of a MEMS acceleration sensor according to a third embodiment of the present invention.

### BEST MODE FOR CARRYING OUT THE INVENTION

In the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof. Also, in the embodiments described below, when referring to the number of elements (including number of pieces, values, amount, range, and others), the number of the elements is not limited to a specific number unless otherwise stated or except the case where the number is apparently limited to a specific number in principle. The number larger or smaller than the specified number is also applicable.

Further, in the embodiments described below, it goes without saying that the components (including element steps) are not always indispensable unless otherwise stated or except the case where the components are apparently indispensable in principle. Similarly, in the embodiments described below, when the shape of the components, positional relation thereof, and others are mentioned, the substantially approximate and similar shapes and others are included therein unless otherwise stated or except the case where it is conceivable that they are apparently excluded in principle. The same goes for the numerical value and the range described above.

### [Summary of embodiment]

First, a summary of the embodiment will be described. In the summary of the present embodiment, the explanation will be made with addition of the corresponding components and reference symbols of each embodiment in parentheses as one example.

The typical inertial sensor of the embodiment is an electrostatic-capacitance inertial sensor having the following features. The inertial sensor includes: a movable unit (movable unit 104, 504, 704); a positive direction first electrode pair (P-side first electrode pair of detection movable electrode 105a, 505a, 705a and detection fixed electrode 106a, 506a, 706a) whose capacitance value is increased by a positive direction displacement of a detection axis of the movable unit; a positive direction second electrode pair (P-side second electrode pair of detection movable electrode 105b, 505b, 705b and detection fixed electrode 106b, 506b, 706b) whose capacitance value is increased by the positive direction displacement of the detection axis of the movable unit; a negative direction first electrode pair (N-side first electrode pair of detection movable electrode 109a, 509a, 709a and detection fixed electrode 110a, 510a, 710a) whose capacitance value decreases with respect to a negative direction displacement of a detection axis of the movable unit; a negative direction second electrode pair (N-side second electrode pair of detection movable electrode 109b, 509b, 709b and detection fixed electrode 110b, 510b, 710b) whose capacitance value decreases with respect to the negative direction displacement of the detection axis of the movable unit.

The movable unit is supported at one point of a fixed portion (fixed portion 101, 501, 701) arranged inside the movable unit. Furthermore, a fixed portion (fixed portion 101, 501, 701) of the movable unit, a fixed portion (fixed portion 107, 507, 707) of the positive direction first electrode pair, a fixed portion (fixed portion 108, 508, 708) of the positive direction second electrode pair, a fixed portion (fixed portion 111, 511, 711) of the negative direction first electrode pair, and a fixed portion (fixed portion 112, 512, 712) of the negative direction second electrode pair are arranged on a line perpendicular to a detection direction (line 116,516,716 perpendicular to detection direction 115, 515, 715) of the inertial sensor. Furthermore, the positive direction first electrode pair and the negative direction first electrode pair are arranged on one side of the fixed portion of the movable unit, and the positive direction second electrode pair and the negative direction second electrode pair are arranged on the other side thereof.

Hereinafter, each embodiment based on the summary of the embodiment described above will be described in detail based on the drawings. Note that the same components are denoted by the same reference symbols throughout all the drawings for describing the embodiments, and the repetitive description thereof will be omitted. Also, in all the drawings, the same hatching is used for the same members in principle commonly in a plan view and a cross-sectional view so as to make each component to be distinguished and easy to see.

In the present embodiment, a MEMS acceleration sensor will be exemplified and described as the inertial sensor. The inertial sensor according to the present embodiment is not limited to this, and can be applied to an inertial sensor for detecting physical quantity having a detection axis caused from an inertia force acting on a substance.

### [First embodiment]

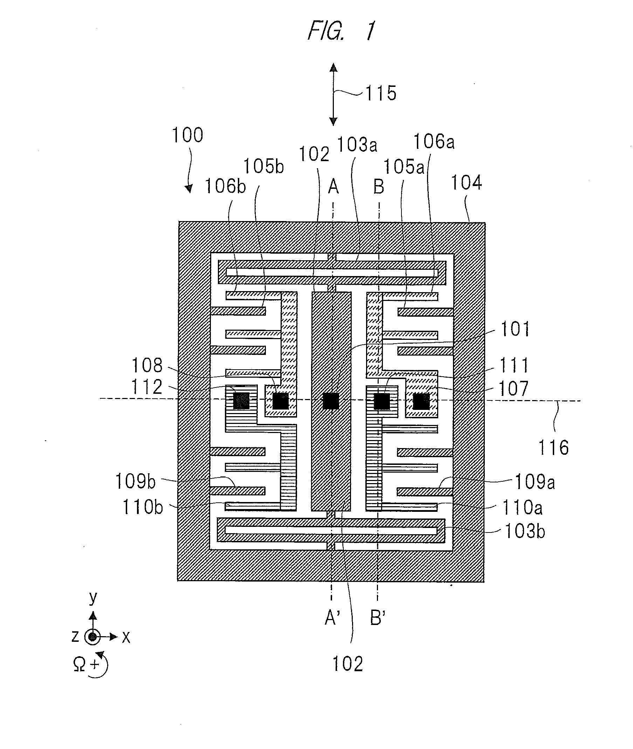

The MEMS acceleration sensor according to the first embodiment will be described by using FIGs.1 to 11.

### <Planar configuration of MEMS acceleration sensor>

First, a planar configuration of the MEMS acceleration sensor according to the present embodiment will be described by using FIG. 1. FIG 1 is a plan view showing one example of a planar configuration of the MEMS acceleration sensor. FIG 1 is a view of the MEMS acceleration sensor seen from an upper surface. Note that the MEMS acceleration sensor having the planar configuration as shown in FIG 1 is referred to as a MEMS acceleration sensor element in some cases. In the following description, the MEMS acceleration sensor or the MEMS acceleration sensor element is simply described as an acceleration sensor, a sensor element, or others in some cases.

The MEMS acceleration sensor 100 according to the present embodiment is an electrostatic-capacitance acceleration sensor, and is configured, as a structural body formed on a substrate, by a fixed portion 101, a rigid body 102, beams 103a, 103b, a movable unit 104, (P-side) detection movable electrodes 105a, 105b, (P-side) detection fixed electrodes106a, 106b, a fixed portion 107, a fixed portion 108, (N-side) detection movable electrodes 109a, 109b, (N-side) detection fixed electrodes 110a, 110b, a fixed portion 111, a fixed portion 112, and others. Note that the beams 103a, 103b are referred to as springs, elastic deforming portions or others. The movable unit 104 is also referred to as a movable unit mass body or others. The detection movable electrodes 105a, 105b, 109a, 109b are also referred to as detection electrode movable units or others, and the detection fixed electrodes 106a, 106b, 110a, 110b are also referred to as detection electrode fixed portions or others.

As shown in FIG 1, the MEMS acceleration sensor 100 according to the present embodiment is provided with the fixed portion 101 on a substrate, the rigid body 102 extending in the detection axis direction (y direction of FIG. 1) is connected to the fixed portion 101, and the upper beam 103a and the lower beam 103b which are deformed in the detection axis direction are connected to the rigid body 102. The upper beam 103a and the lower beam 103b are connected to the movable unit 104 serving as a proof mass of the MEMS acceleration sensor 100. That is, the fixed portion 101 is supported by the substrate, and the fixed portion 101 and the movable unit 104 are connected to each other by the elastically deformable beams 103a, 103b so that the movable unit 104 can displace in the y direction of FIG. 1. The y direction of FIG 1 becomes a detection direction 115 of the MEMS acceleration sensor 100. Note that the detection direction 115 is also referred to as a detection axis direction or others.

The detection movable electrodes 105a, 105b, 109a, 109b integrally formed with the movable unit 104 are formed in the movable unit 104, and the detection fixed electrodes 106a, 106b, 110a, 110b are formed so as to face the detection movable electrodes 105a, 105b, 109a, and 109b, respectively. The detection fixed electrodes 106a, 106b, 110a, 110b are supported on the substrate via the fixed portions 107, 108, 111, 112, respectively The fixed portion 107 of the detection fixed electrode 106a, the fixed portion 108 of the detection fixed electrode 106b, the fixed portion 111 of the detection fixed electrode 110a, the fixed portion 112 of the detection fixed electrode 110b, and the fixed portion 101 supporting the movable unit 104 at one point are arranged on the line 116 perpendicular to the detection direction 115 of the MEMS acceleration sensor 100.

The detection movable electrode 105a and the detection fixed electrode 106a, as well as the detection movable electrode 105b and the detection fixed electrode 106b are placed in a first direction (plus direction of y direction of FIG. 1) with respect to the line 116 perpendicular to the detection direction 115 of the acceleration sensor passing through the fixed portion 101 of the movable unit 104. In other words, the P-side first electrode pair formed of the detection movable electrode 105a and the detection fixed electrode 106a is arranged at the upper right position of FIG 1, and the P-side second electrode pair formed of the detection movable electrode 105b and the detection fixed electrode 106b is arranged at the upper left position thereof These arrangements are line symmetric to each other with respect to the line 116.

Also, the detection movable electrode 109a and the detection fixed electrode 110a, as well as the detection movable electrode 109b and the detection fixed electrode 110b are placed in a second direction (minus direction of y direction of FIG 1) which is different from the first direction, with respect to the line 116 perpendicular to the detection direction 115 of the acceleration sensor passing through the fixed portion 101 of the movable unit 104. In other words, the N-side first electrode pair formed of the detection movable electrode 109a and the detection fixed electrode 110a is arranged at the lower right position of FIG 1, and the N-side second electrode pair formed of the detection movable electrode 109b and the detection fixed electrode 110b is arranged at the lower left position thereof. These arrangements are line symmetric to each other with respect to the line 116.

Furthermore, in FIG. 1, the P-side first electrode pair formed of the detection movable electrode 105a and the detection fixed electrode 106a, the P-side second electrode pair formed of the detection movable electrode 105b and the detection fixed electrode 106b, the N-side first electrode pair formed of the detection movable electrode 109a and the detection fixed electrode 110a, and the N-side second electrode pair formed of the detection movable electrode 109b and the detection fixed electrode 110b are arranged in two pairs. Each electrode pair is formed from a facing-type parallel plate shape whose capacitance value is varied by the inter-electrode distance between each detection movable electrode and each detection fixed electrode. Note that the P-side is referred to as positive direction, plus direction, or others, and the N-side is also referred to as negative direction, minus direction, or others.

In these electrode pairs, the detection movable electrode 105a and the detection fixed electrode 106a, or the detection movable electrode 105b and the detection fixed electrode 106b form a capacitive element, and the capacitance of each capacitive element increases when the movable unit 104 is displaced in the plus direction of y direction by the externally applied acceleration. Also, the detection movable electrode 109a and the detection fixed electrode 110a, or the detection movable electrode 109b and the detection fixed electrode 110b form a capacitive element, and the capacitance of each capacitive element decreases when the movable unit 104 is displaced in the plus direction of y direction by the externally applied acceleration. That is, the capacitive element configured from the detection movable electrode 105a and the detection fixed electrode 106a, the detection movable electrode 105b and the detection fixed electrode 106b, the detection movable electrode 109a and the detection fixed electrode 110a, or the detection movable electrode 109b and the detection fixed electrode 110b functions as a capacitance detection unit for detecting the displacement of the movable unit 104 in the y direction as a change in the capacitance.

The structural body of the MEMS acceleration sensor 100 configured as described above is made of a semiconductor material such as silicon. Therefore, the fixed portion 101 and the movable unit 104 connected to each other via the beams 103a, 103b and the rigid body 102 are electrically connected to each other, so that the electric potential applied on the movable unit 104 is supplied from a through electrode connected to the fixed portion 101 or a wire bonding wiring. Meanwhile, each of the fixed portion 107 of the detection fixed electrode 106a, the fixed portion 108 of the detection fixed electrode 106b, the fixed portion 111 of the detection fixed electrode 110a, and the fixed portion 112 of the detection fixed electrode 110b is connected also with the through electrode or the wire bonding wiring, and they are configured so that the charges can be flowed into or flowed out from the detection fixed electrodes 106a, 106b and the detection fixed electrodes 110a, 110b by the change in capacitance caused by the displacement of the movable unit 104 in the y direction.

In the structural body of the MEMS acceleration sensor 100, the movable unit 104 is formed from a frame body including a square outer perimeter frame and an inner perimeter frame. The rigid body 102 supported by the fixed portion 101 is formed into a rectangular shape that is long in the y direction of FIG 1. Each of the beams 103a, 103b is formed into a rectangular frame body that is long in the x direction of FIG 1. The outer perimeter frames of the frame bodies of the beams 103a, 103b are coupled to the inner perimeter frame of the frame body of the movable unit 104 at one point. Further, on the opposing side, the outer perimeter frames of the frame bodies of the beams 103a, 103b are coupled to the short sides of the rectangle of the rigid body 102 at one point, respectively.

On the inner side of the frame body of the movable unit 104, that is, on the inner side of the inner perimeter frame of the frame body (in the space on the inner side of the frame body), the P-side first electrode pair formed of the detection movable electrode 105a and the detection fixed electrode 106a, the P-side second electrode pair formed of the detection movable electrode 105b and the detection fixed electrode 106b, the N-side first electrode pair formed of the detection movable electrode 109a and the detection fixed electrode 110a, and the N-side second electrode pair formed of the detection movable electrode 109b and the detection fixed electrode 110b are arranged. Among them, each of the detection movable electrodes 105a, 105b, 109a, 109b is formed into a rectangle protruding inward from the inner perimeter frame of the frame body of the movable unit 104. The detection fixed electrodes 106a, 106b, 110a, 110b are each formed into a rectangle protruding from a linear or an L-shaped member supported by the fixed portions 107, 108, 111, 112 so as to face the detection movable electrodes 105a, 105b, 109a, 109b.

### <Circuit configuration of MEMS acceleration sensor>

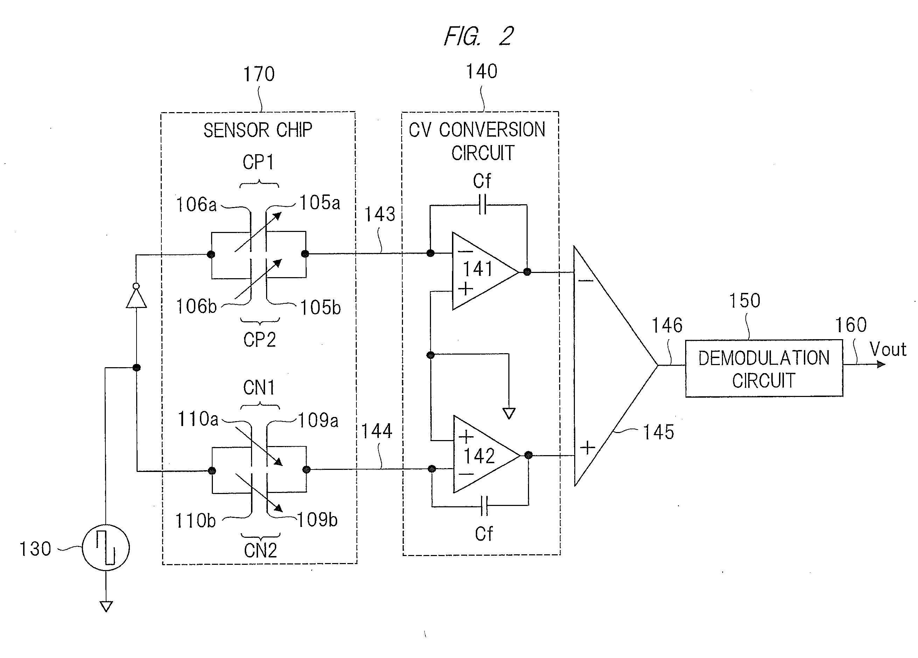

Subsequently, a circuit configuration of the MEMS acceleration sensor according to the present embodiment will be described by using FIG 2. FIG 2 is a circuit diagram showing one example of the circuit configuration of the MEMS acceleration sensor.

As shown in FIG 2, the MEMS acceleration sensor is configured by a sensor chip 170 formed with the mechanical element, a capacitance-voltage (CV) conversion circuit 140 serving as a detection circuit, a differential detection circuit 145, a carrier wave applying circuit 130, a demodulation circuit 150, an output terminal 160, and others.

The structural body (movable unit 104, beams 103a, 103b, rigid body 102, detection movable electrodes 105a, 105b, 109a, 109b, detection fixed electrodes 106a, 106b, 110a, 110b, etc.) formed on the substrate shown in FIG 1 is formed on the sensor chip 170. Here, the P-side first electrode pair (capacitive element CP1) formed of the detection movable electrode 105a and the detection fixed electrode 106a, the P-side second electrode pair (capacitive element CP2) formed of the detection movable electrode 105b and the detection fixed electrode 106b, the N-side first electrode pair (capacitive element CN1) formed of the detection movable electrode 109a and the detection fixed electrode 110a, and the N-side second electrode pair (capacitive element CN2) formed of the detection movable electrode 109b and the detection fixed electrode 110b forming the capacitive elements are illustrated.

By the sensor chip 170, the change in capacitance values of the capacitive elements CP1, CP2, CN1, CN2 are detected. From the sensor chip 170, a detection signal 143 indicating the capacitance value change of the capacitive element CP1 and the capacitive element CP2 and a detection signal 144 indicating the capacitance value change of the capacitive element CN1 and the capacitive element CN2 are outputted. The detection signals 143, 144 indicating the capacitance value change from the sensor chip 170 are inputted to negative input terminals (-) of the operational amplifiers 141, 142 of the CV conversion circuit 140 outside the sensor chip 170, respectively. Positive input terminals (+) of the operational amplifiers 141, 142 are connected to the ground. A capacitive element Cf is connected between the negative input terminal (-) and the output terminal of the operational amplifiers 141,142.

In the CV conversion circuit 140, the detection signals 143,144 indicating the capacitance value change from the sensor chip 170 are converted to voltage change, and the amount of the voltage change is detected by the differential detection circuit 145. Furthermore, an electric potential difference signal 146 from the differential detection circuit 145 can be measured by the carrier wave generated and demodulated by the carrier wave applying circuit 130 and the demodulation circuit 150, can be converted to the displacement amount of the movable unit 104, and can be outputted from the output terminal 160.

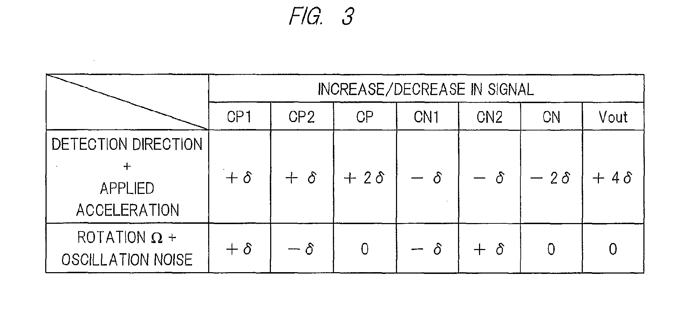

In the following, in the MEMS acceleration sensor, <<case of acceleration input>> and <<case of rotation noise input>> will be described by using FIG 3 with reference to FIG 2 described above. FIG 3 is an explanatory diagram showing one example of increase/decrease of the signal in each electrode obtained when the acceleration (applied detection direction + acceleration) and the rotation noise (rotation Ω + oscillation noise) are inputted to the MEMS acceleration sensor. In FIG. 3, "δ" indicates the change amount, "+" indicates increase, and "-"indicates decrease.

### «Case of acceleration input»

The detection movable electrode 105a and the detection fixed electrode 106a form the capacitive element CP1, and the capacitance of the capacitive element CP1 increases (by + δ) as shown in FIG 3 when the movable unit 104 is displaced in the plus direction (y positive direction of FIG 1) of the detection axis (detection direction 115) by the externally applied acceleration. Furthermore, the detection movable electrode 105b and the detection fixed electrode 106b form the capacitive element CP2, and the capacitance of the capacitive element CP2 increases (by + δ) as shown in FIG 3 when the movable unit 104 is displaced in the plus direction (y positive direction of FIG 1) of the detection axis (detection direction 115) by the externally applied acceleration.

The capacitive element CP1 and the capacitive element CP2 are connected to each other by electrical means such as the wire bonding or the through electrode wiring, and are summed to become the capacitance value CP at the stage previous to the input of the CV conversion circuit 140 which is a computation circuit. Thus, when the movable unit 104 is displaced in the plus direction (y positive direction of FIG 1) of the detection axis (detection direction 115) by the externally applied rotary acceleration, the capacity variation value (+ δ) of the capacitive element CP1 and the capacity variation value (+ δ) of the capacitive element CP2 are summed, so that the capacitance value CP is doubled (to become + 2δ) as shown in FIG. 3.

The detection movable electrode 109a and the detection fixed electrode 110a form the capacitive element CN1, and the capacitance of the capacitive element CN1 decreases (by - δ) as shown in FIG 3 when the movable unit 104 is displaced in the plus direction (y positive direction of FIG 1) of the detection axis (detection direction 115) by the externally applied acceleration. The detection movable electrode 109b and the detection fixed electrode 110b form the capacitive element CN2, and the capacitance of the capacitive element CN2 decreases (by - δ) as shown in FIG. 3 when the movable unit 104 is displaced in the plus direction (y positive direction of FIG 1) of the detection axis (detection direction 115) by the externally applied acceleration.

The capacitive element CN1 and the capacitive element CN2 are connected to each other by electrical means such as a wire bonding or a through electrode wiring, and are summed to become the capacitance value CN at the stage previous to the input of the CV conversion circuit 140 which is a computation circuit. Thus, when the movable unit 104 is displaced in the plus direction (y positive direction of FIG. 1) of the detection axis (detection direction 115) by the externally applied rotary acceleration, the capacity variation value (- δ) of the capacitive element CN1 and the capacity variation value (- δ) of the capacitive element CN2 are summed, so that the capacitance value CN is doubled (to become - 2δ) as shown in FIG 3.

The change in the capacitance value of each capacitor is converted to a voltage change by the CV conversion circuit 104 outside the sensor chip 170, the change amount of the voltage is detected by the differential detection circuit 145, and this electric potential difference is measured by the carrier wave generated and demodulated by the carrier wave applying circuit 130 and the demodulation circuit 150, is converted to a displacements amount of the movable unit 104, and is outputted from the output terminal 160.

As described above, the output from the output terminal (Vout) obtained when the movable unit 104 is displaced in the plus direction (y positive direction of FIG 1) of the detection axis (detection direction 115) by the externally applied acceleration becomes (+ 4δ) by the differential computation of (+ 2δ) and (- 2δ) as shown in FIG 3. In other words, the output signal which is plus four times the change amount is obtained.

### «Case of rotation noise input»

On the other hand, the detection movable electrode 105a and the detection fixed electrode 106a form the capacitive element CP1, and the capacitance of the capacitive element CP1 increases (by + δ) as shown in FIG 3 when the movable unit 104 is displaced in the counterclockwise direction (z positive direction of FIG 1 is the rotation axis) in the direction perpendicular to the sheet of FIG 1 by the externally applied rotary acceleration. Furthermore, the detection movable electrode 105b and the detection fixed electrode 106b form the capacitive element CP2, and the capacitance of the capacitive element CP2 decreases (by - δ) as shown in FIG 3 when the movable unit 104 is displaced in the counterclockwise direction (z positive direction of FIG 1 is the rotation axis) in the direction perpendicular to the sheet of FIG. 1 by the externally applied rotary acceleration.

The capacitive element CP1 and the capacitive element CP2 are connected to each other by electrical means such as the wire bonding or the through electrode wiring, and are summed to become the capacitance value CP at the stage previous to the input of the CV conversion circuit 140 which is a computation circuit. Thus, when the movable unit 104 is displaced in the counterclockwise direction (z positive direction of FIG 1 is the rotation axis) in the direction perpendicular to the sheet of FIG 1 by the externally applied rotary acceleration, the capacity variation value (+ δ) of the capacitive element CP1 and the capacity variation value (- δ) of the capacitive element CP2 are canceled from each other, so that the capacitance value CP becomes zero (0) as shown in FIG 3.

The detection movable electrode 109a and the detection fixed electrode 110a form the capacitive element CN1, and the capacitance of the capacitive element CN1 decreases (by - δ) as shown in FIG 3 when the movable unit 104 is displaced in the counterclockwise direction (z positive direction of FIG 1 is the rotation axis) in the direction perpendicular to the sheet of FIG 1 by the externally applied rotary acceleration. The detection movable electrode 109b and the detection fixed electrode 110b form the capacitive element CN2, and the capacitance of the capacitive element CN2 increases (by + δ) as shown in FIG 3 when the movable unit 104 is displaced in the counterclockwise direction (z positive direction of FIG 1 is the rotation axis) in the direction perpendicular to the sheet of FIG 1 by the externally applied rotary acceleration.

The capacitive element CN1 and the capacitive element CN2 are connected to each other by electrical means such as a wire bonding or a through electrode wiring, and are summed to become the capacitance value CN at the stage previous to the input of the CV conversion circuit 140 which is a computation circuit. Thus, when the movable unit 104 is displaced in the counterclockwise direction (z positive direction of FIG 1 is the rotation axis) in the direction perpendicular to the sheet of FIG 1 by the externally applied rotary acceleration, the capacity variation value (- δ) of the capacitive element CN1 and the capacity variation value (+ δ) of the capacitive element CN2 are cancelled from each other, so that the capacitance value CN becomes zero (0) as shown in FIG 3.

The change in the capacitance value of each capacitor is converted to a voltage change by the CV conversion circuit 104 outside the sensor chip 170, the amount of the voltage change is detected by the differential detection circuit 145, and this electric potential difference is measured by the carrier wave generated and demodulated by the carrier wave applying circuit 130 and the demodulation circuit 150, is converted to a displacements amount of the movable unit 104, and is outputted from the output terminal 160.

As described above, the output from the output terminal (Vout) obtained when the movable unit 104 is displaced in the counterclockwise direction (z positive direction of FIG 1 is the rotation axis) in the direction perpendicular to the sheet of FIG 1 by the externally applied acceleration becomes (0) by the differential computation of (0) and (0) as shown in FIG 3. In this manner, when the movable unit 104 is displaced in the counterclockwise direction (z positive direction of FIG 1 is the rotation axis) in the direction perpendicular to the sheet of FIG 1 by the externally applied rotary acceleration, the variation of the capacitance value is canceled out in the sensor chip 170 where the mechanical element is configured, and therefore, the signal is not inputted to the computation circuit.

In other words, it is not required to assume a case that the electric signal exceeds a range in which the signal can be handled by the LSI circuit, that is, a case that the LSI circuit causes saturation, and therefore, the electric signal does not cause the function stop of the acceleration sensor caused when the signal to be essentially measured is buried in the saturation signal. That is, by cancelling the signal caused by the applied acceleration other than the measurement signal before the input to the LSI circuit, the function stop due to the false operation and the false output of the acceleration sensor caused by the applied acceleration other than the measurement signal can be suppressed.

### <Cross-sectional configuration of MEMS acceleration sensor>

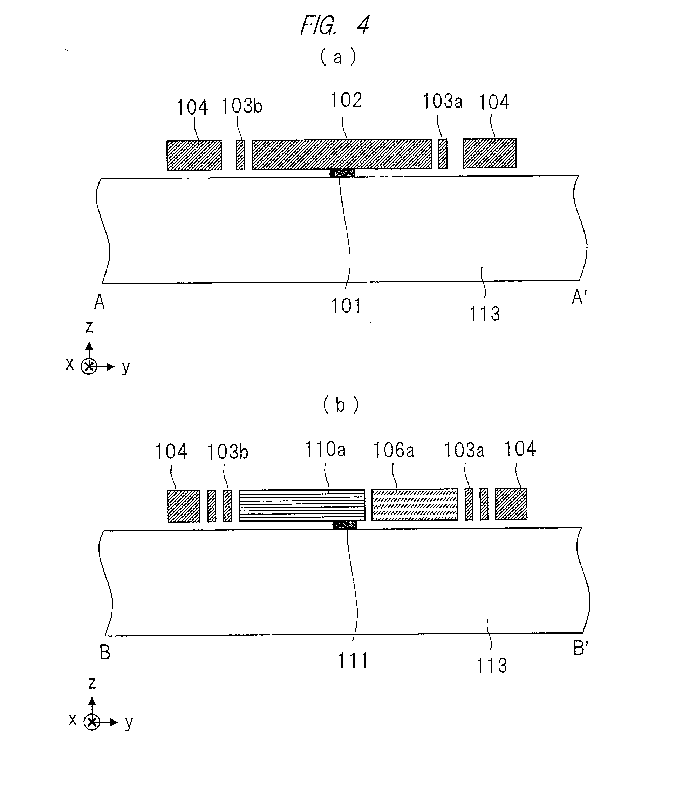

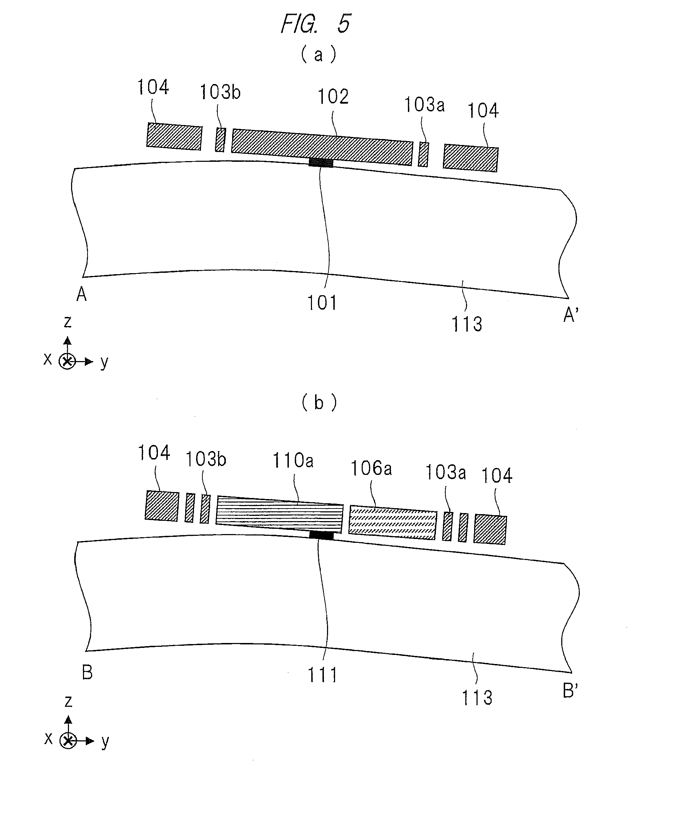

Subsequently, a cross-sectional configuration of the MEMS acceleration sensor according to the present embodiment will be described by using FIGs. 4 and 5. FIGs. 4 and 5 are cross-sectional views each showing an example of the cross-sectional configuration of the MEMS acceleration sensor, FIG 4 shows a case that the substrate is not deformed, and FIG 5 shows a case that the substrate is deformed.

### <<Case that the substrate is not deformed>>

FIG 4 is a cross-sectional view showing one example of a cross-sectional configuration obtained when the substrate of the MEMS acceleration sensor is not deformed. The cross-sectional views of FIG 4 is shown in a direction along the detection axis of the MEMS acceleration sensor, FIG 4(a) corresponds to a cross-sectional surface taken along a line A-A' in FIG 1, and FIG 4(b) corresponds to a cross-sectional surface taken along a line B-B' in FIG. 1.

As shown in FIG 4(a), the fixed portion 101 is arranged on the substrate 113, the rigid body 102 extending in the detection axis direction (y direction of FIG. 4) is connected to the fixed portion 101, and the beam 103a and the beam 103b that deform in the detection axis direction are further connected from the rigid body 102. The beam 103a and the beam 103b are connected to the movable unit 104 serving as the proof mass of the MEMS acceleration sensor. The fixed portion 101 and the substrate 113 are fixed at one point near the center of the movable unit 104 (on the line 116 perpendicular to the detection direction (detection axis) 115 shown in FIG 1).

As shown in FIG 4(b), the fixed portion 111 is arranged on the substrate 113, and the detection fixed electrode 110a is connected to the fixed portion 111. The fixed portion 111 and the substrate 113 are fixed at one point near the center of the movable unit 104 (on the line 116 perpendicular to the detection direction (detection axis) 115 shown in FIG. 1).

The fixed portion 107 shown in FIG 1 is arranged in a direction perpendicular to the sheet of FIG 4, and the detection fixed electrode 106a is connected to the fixed portion 107. The fixed portion 107 and the substrate 113 are also similarly fixed at one point near the center of the movable unit 104. Furthermore, the fixed portions 108, 112 shown in FIG 1 are similarly arranged in the direction perpendicular to the sheet of FIG 4. The detection fixed electrodes 106b, 110b are connected to the fixed portions 108, 112, respectively. The fixed portions 108, 112 and the substrate 113 are also similarly fixed at one point near the center of the movable unit 104.

### <<Case that the substrate is deformed>>

Subsequently, FIG 5 is a cross-sectional view showing one example of a cross-sectional configuration obtained when the substrate of the MEMS acceleration sensor is deformed. The cross-sectional views of FIG 5 is shown in a direction along the detection axis of the MEMS acceleration sensor as similar to the above-described FIG 4, FIG 5(a) corresponds to a cross-sectional surface taken along a straight line shown as a line A-A' in FIG 1, and FIG 5(b) corresponds to a cross-sectional surface taken along a straight line shown as a line B-B' in FIG 1. Also, the deformation of the substrate in this case does not curve as having a certain curvature taken along the lines A-A' and B-B', but causes nonlinear deformation.

As shown in FIG 5(a), the fixed portion 101 arranged on the substrate 113 is deformed by the nonlinear deformation of the substrate 113. The deformation in this case is such deformation as changing an angle of fixation between the substrate 113 and the rigid body 102 extending in the detection axis direction (y direction of FIG 5), the beam 103a and beam 103b connected to the rigid body 102 and deformed in the detection axis direction, and the movable unit 104 connected through the beam 103a and the beam 103b. The angle of fixation depends on the local curvature ofthe deformation of the substrate 113 placed with the fixed portion 101.

Furthermore, as shown in FIG 5(b), the fixed portion 111 arranged on the substrate 113 is deformed by the nonlinear deformation of the substrate 113. The deformation in this case is such deformation as changing an angle of fixation between the fixed portion 111 and the substrate 113. The angle of fixation depends on the local curvature of the deformation of the substrate 113 placed with the fixed portion 111, and is the same as the local curvature of the deformation ofthe substrate 113 placed with the fixed portion 101 ofthe movable unit 104 described above.

The fixed portions 107,108,112 shown in FIG 1 arranged in the direction perpendicular to the sheet of FIG 5 also similarly is deformed by the nonlinear deformation of the substrate 113. The deformation in this case is such deformation as changing an angle of fixation between the substrate 113 and the fixed portions 107,108,112. The angle of fixation depends on the local curvature of the deformation of the substrate 113 placed with the fixed portions 107,108, 112, and is the same as the local curvature of the deformation of the substrate 113 placed with the fixed portion 101 of the movable unit 104 described above.

In the MEMS acceleration sensor according to the present embodiment, all ofthe fixed portions 101, 111, 107, 108,112 are placed on the line 116 perpendicular to the detection axis. Therefore, for example, the change in the angle of fixation caused by the deformation of the substrate 113 depends on the local curvature of the deformation of the substrate 113 placed with the fixed portion 111 shown in FIG 5(b), and therefore, the components connected to all of the fixed portions are deformed at the same angle of fixation by the nonlinear deformation of the substrate 113. That is, regardless of how the substrate 113 is deformed along the detection axis direction of the MEMS acceleration sensor, all ofthe detection movable electrodes 105a, 105b, 109a, 109b arranged on the movable unit 104 of the MEMS acceleration sensor, the detection fixed electrodes 106a, 106b, 110a, 110b connected to the fixed portion 111 and other fixed portions 107, 108, 112, and others are deformed at the same angle with respect to the substrate 113, and therefore, the relative distance to each other does not change.

Therefore, the capacitance values configured by the electrode pair formed of the respective detection movable electrodes 105a, 105b, 109a, 109b and detection fixed electrodes 106a, 106b, 110a, 110b are not varied by the deformation of the substrate 113. Therefore, the MEMS acceleration sensor according to the present embodiment does not show an offset variation caused by the deformation of the substrate 113.

### <Planar configuration and cross-sectional configuration of MEMS acceleration sensor of the conventional technique>

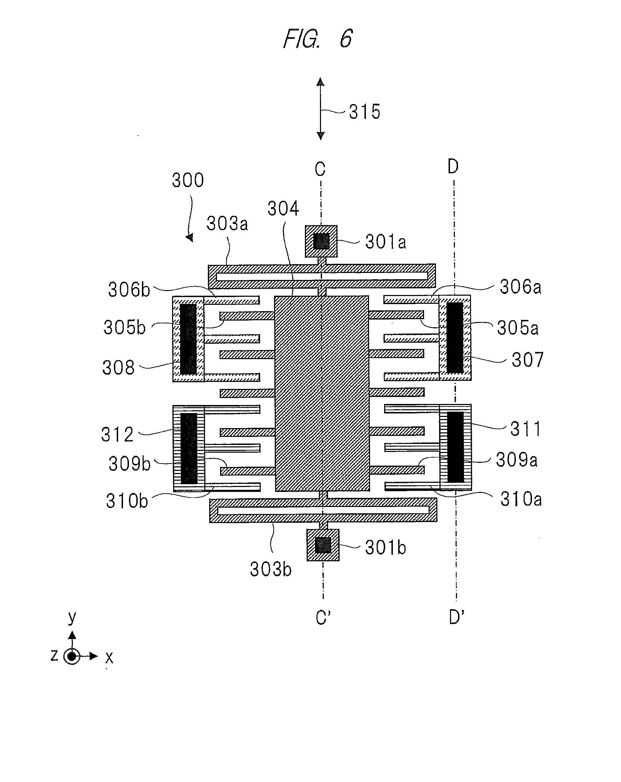

A typical MEMS acceleration sensor manufactured by the conventional technique will be described by using FIGs. 6 to 8 in comparison with the MEMS acceleration sensor according to the present embodiment described by using FIGs. 1 to 5 in order to easily understand the features of the present embodiment.

### «Planar configuration of MEMS acceleration sensor of Conventional technique»

FIG 6 is a plan view showing one example of a planar configuration of the MEMS acceleration sensor according to a conventional technique. FIG 6 is a view of the MEMS acceleration sensor seen from the upper surface.

AMEMS acceleration sensor 300 according to the conventional technique includes two fixed portions 301a, 301b arranged on a substrate, and a beam 303a and a beam 303b that deform in the detection axis direction (detection direction 315, y direction of FIG 6) are connected to the fixed portions 301a, 301b. The beam 303a and the beam 303b are connected to the movable unit 304 serving as a proof mass of the MEMS acceleration sensor 300.

The detection movable electrodes 305a, 305b, 309a, 309b integrally formed with the movable unit 304 are formed in the movable unit 304, and detection fixed electrodes 306a, 306b, 310a, 310b are formed so as to face the detection movable electrodes 305a, 305b, 309a, 309b.

The detection movable electrode 305a and the detection fixed electrode 306a, or the detection movable electrode 305b and the detection fixed electrode 306b form a capacitive element, and the capacitance of each capacitive element increases when the movable unit 304 is displaced in the plus direction of y direction by the externally applied acceleration. Furthermore, the detection movable electrode 309a and the detection fixed electrode 310a, or the detection movable electrode 309b and the detection fixed electrode 310b form a capacitive element, and the capacitance of each capacitive element decreases when the movable unit 304 is displaced in the plus direction of y direction by the externally applied acceleration. That is, the capacitive element configured by the detection movable electrode 305a and the detection fixed electrode 306a, the detection movable electrode 305b and the detection fixed electrode 306b, the detection movable electrode 309a and the detection fixed electrode 310a, or the detection movable electrode 309b and the detection fixed electrode 310b functions as a capacitance detection unit that detects the displacement in the y direction of the movable unit 304 as the change in capacitance.

The structural body of the MEMS acceleration sensor 300 configured as described above is made of a semiconductor material such as silicon. Therefore, the fixed portions 301 a, 301b and the movable unit 304 connected to each other through the beams 303a, 303b are electrically connected to each other, and the electric potential applied on the movable unit 304 is supplied from the through electrode and the wire bonding wiring connected to the fixed portions 301a, 301b. Meanwhile, the fixed portion 307 of the detection fixed electrode 306a, the fixed portion 308 of the detection fixed electrode 306b, the fixed portion 311 of the detection fixed electrode 310a, and the fixed portion 312 of the detection fixed electrode 310b are also connected with the through electrode and the wire bonding wiring, so that the charges can flow into or flow out from the detection fixed electrodes 306a, 306b and the detection fixed electrodes 310a, 310b by the change in capacitance caused by the displacement of the movable unit 304 in the y direction.

### <Cross-sectional configuration of MEMS acceleration sensor of Conventional technique>

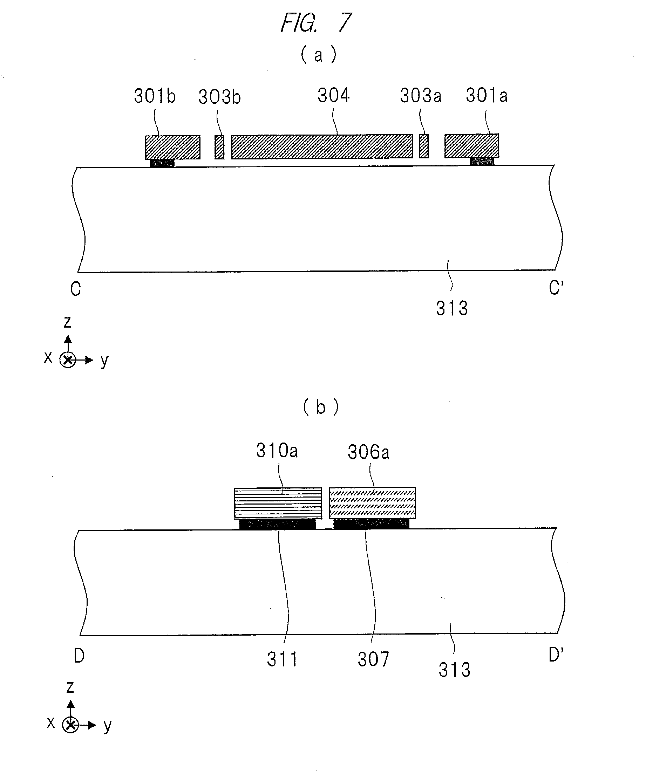

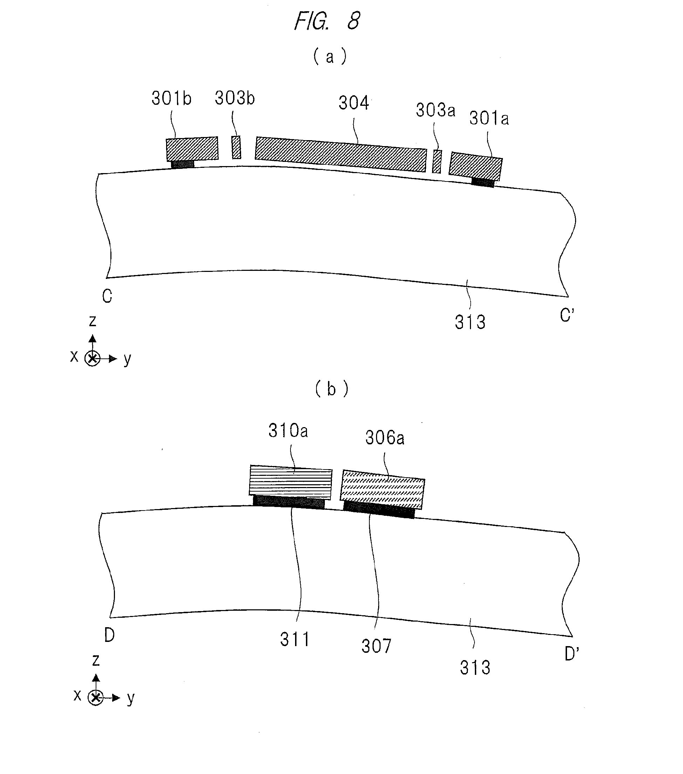

Subsequently, a cross-sectional configuration of the MEMS acceleration sensor according to the conventional technique will be described by using FIGs. 7 and 8. FIGs. 7 and 8 are cross-sectional views each showing an example of the cross-sectional configuration of this MEMS acceleration sensor, FIG 7 shows a case that the substrate is not deformed, and FIG 8 shows a case that the substrate is deformed.

### <<Case that the substrate is not deformed>>

FIG 7 is a cross-sectional view showing one example of a cross-sectional configuration obtained when the substrate of the MEMS acceleration sensor of the conventional technique is not deformed. The cross-sectional views of FIG 7 are shown in a direction along the detection axis of the MEMS acceleration sensor, FIG 7(a) corresponds to a cross-sectional surface taken along a line C-C' in FIG. 6, and FIG 7(b) corresponds to a cross-sectional surface taken along a line D-D' in FIG. 6.

As shown in FIG 7(a), the fixed portions 301a, 301b at two positions are arranged on the substrate 313, the beam 303a and the beam 303b that deform in the detection axis direction (y direction of FIG 7) are connected from these fixed portions 301a, 301b. The beam 303a and the beam 303b are connected to the movable unit 304 serving as the proof mass of the MEMS acceleration sensor. The fixed portions 301a, 301b and the substrate 313 are fixed at two points on both sides pf the movable unit 304.

As shown in FIG. 7(b), the fixed portion 307 is arranged on the substrate 313, and the detection fixed electrode 306a is connected to the fixed portion 307. The fixed portion 307 and the substrate 313 are fixed to each other with a width in the direction along the detection axis of the MEMS acceleration sensor. Furthermore, the fixed portion 311 is arranged on the substrate 313, and the detection fixed electrode 310a is connected to the fixed portion 311. The fixed portion 311 and the substrate 313 are fixed to each other with a width in the direction along the detection axis of the MEMS acceleration sensor.

### <<Case that the substrate is deformed>>

Subsequently, FIG 8 is a cross-sectional view showing one example of a cross-sectional configuration obtained when the substrate of the MEMS acceleration sensor is deformed. The cross-sectional views of FIG 8 is shown in a direction along the detection axis of the MEMS acceleration sensor as similar to the above-described FIG 7, FIG 8(a) corresponds to a cross-sectional surface taken along a straight line shown as a line C-C' in FIG 6, and FIG 8(b) corresponds to a cross-sectional surface taken along a straight line shown as a line D-D' in FIG 6. Also, the deformation of the substrate in this case does not curve as having a certain curvature taken along the lines C-C' and D-D', but causes nonlinear deformation.

As shown in FIG 8(a), the fixed portions 301a, 301b arranged two positions on the substrate 313 are deformed by the nonlinear deformation of the substrate 313. The deformation in this case is such deformation as changing an angle of fixation between the substrate 313 and the movable unit 304 connected through the beam 303a and the beam 303b deformed in the detection axis direction (y direction of FIG 8). The angle of fixation depends on the local curvature of the deformation of the substrate 313 placed with each of the fixed portions301a, 301b.

Furthermore, as shown in FIG 8(b), the fixed portion 311 arranged on the substrate 313 is deformed by the nonlinear deformation of the substrate 313. The deformation in this case is such deformation as changing an angle of fixation between the fixed portion 311 and the substrate 313. The angle of fixation depends on the local curvature of the deformation of the substrate 313 placed with the fixed portion 311, and is the same as the local curvature of the deformation of the substrate 313 placed with each of the fixed portions 301a, 301b of the movable unit 104 described above.

The fixed portion 307 arranged on the substrate 313 is deformed by the nonlinear deformation of the substrate 313. The deformation in this case is such deformation as changing an angle of fixation between the fixed portion 307 and the substrate 313. The angle of fixation depends on the local curvature of the deformation of the substrate 313 placed with the fixed portion 307, and may not be always the same as the local curvature of the deformation of the substrate 313 placed with each of the fixed portions 301a, 301b of the movable unit 304 described above and the local curvature of the deformation of the substrate 313 placed with the fixed portion 311 described above.

In the MEMS acceleration sensor according to the conventional technique, all the fixed portions 301a, 301b, 311, 307, 308, 312 onto the substrate 313 are arranged while being distributed with respect to the detection axis. The change in the angle of fixation caused by the deformation of the substrate 313 depends on the local curvature of the deformation of the substrate 313 placed with each of the fixed portions, and therefore, components connected to all the fixed portions may not be always deformed at the same angle of fixation by the nonlinear deformation of the substrate 313. That is, when the substrate 313 is nonlinearly deformed along the detection axis direction of the MEMS acceleration sensor, all of the detection movable electrodes 305a, 305b, 309a, 309b arranged in the movable unit 304 of the MEMS acceleration sensor, the detection fixed electrodes 306a, 306b, 310a, 310b connected to the fixed portions 311, 307 and other fixed portions 308, 312, and others may not be always deformed at the same angle with respect to the substrate 313.

Thus, there is a possibility of changing the relative distance to each other by the nonlinear deformation of the substrate 313. That is, there is a possibility of the variation in the capacitance value configured by the electrode pairs formed of the detection movable electrode 305a, 305b, 309a, 309b and the detection fixed electrode 306a, 306b, 310a, 310b by the deformation of the substrate 313. The typical MEMS acceleration sensor manufactured by the conventional technique as described above has a possibility of showing the offset variation caused by the deformation of the substrate 313.

### <Comparison between MEMS acceleration sensor according to present embodiment and MEMS acceleration sensor according to conventional technique>

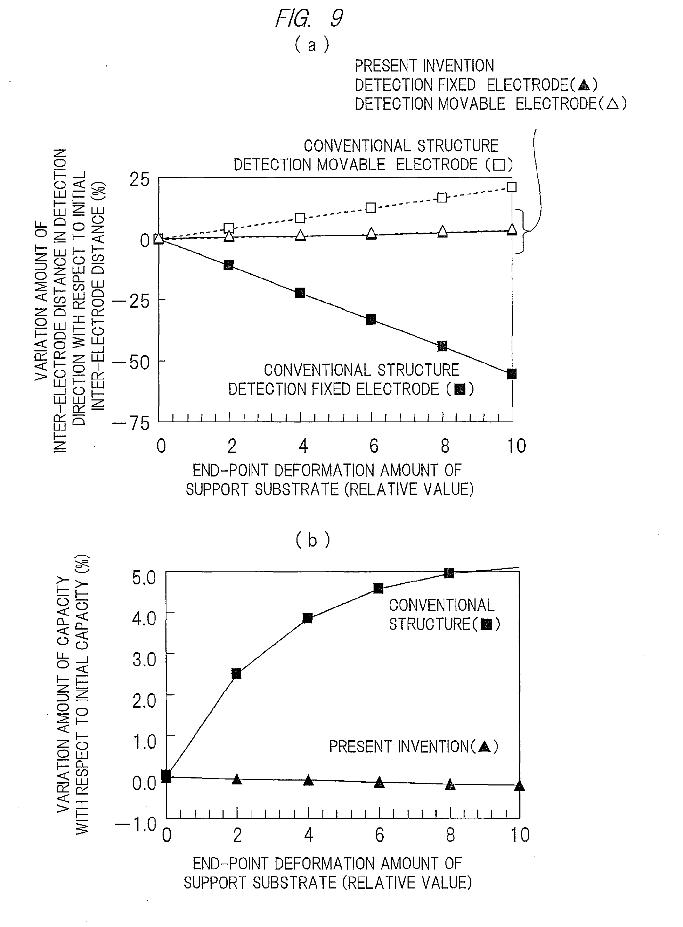

Subsequently, the comparison between the MEMS acceleration sensor according to the present embodiment described above (FIGs. 1 to 5) and the MEMS acceleration sensor according to the conventional technique described above (FIGs. 6 to 8) will be described by using FIG 9. FIG 9 is a graph showing one example of analyzing results of the variation amount of the inter-electrode distance for the nonlinear deformation of the substrate caused in the detection axis direction and of the converted offset variation amount (variation amount of capacitance) in the comparison between the MEMS acceleration sensor according to the present embodiment and the MEMS acceleration sensor according to the conventional technique.

In FIG 9(a), the horizontal axis indicates the end point deformation amount (relative value) of the supporting substrate, and the vertical axis indicates the variation amount (%) of the inter-electrode distance in the detection direction with respect to the initial inter-electrode distance. In FIG 9(b), the horizontal axis indicates the end point deformation amount (relative value) of the supporting substrate, and the vertical axis indicates the variation amount (%) of the capacitance with respect to the initial capacitance.

In the MEMS acceleration sensor (conventional structure) according to the conventional technique, different values of the variation from when the substrate is not deformed are caused between the detection fixed electrode and the detection movable electrode by the addition of the nonlinear deformation of the substrate caused in the detection axis direction in the detection fixed electrode and the detection movable electrode as shown in FIG 9(a). In the example of FIG 9(a), for example, if the deformation amount (relative value) of the substrate is "10", the variation amounts are about "-55%" in the detection fixed electrode and about "+20%" in the detection movable electrode. As a result, the variation in the relative distance between the detection fixed electrode and the detection movable electrode occurs.

As the result of the variation in the relative distance between the detection fixed electrode and the detection movable electrode, the variation in the capacitance value configured by the electrode pair formed of the detection fixed electrode and the detection movable electrode occurs as shown in FIG 9(b), and the offset variation appears. In the example of FIG 9(b), for example, if the deformation amount (relative value) of the substrate is "10", the variation amount of the capacitance is about "5.0%".

On the other hand, in the MEMS acceleration sensor (the present invention) according to the present embodiment, even with the addition of the nonlinear deformation of the substrate caused in the detection axis direction, the variation from when the substrate is not deformed is small in the detection fixed electrode and the detection movable electrode as shown in FIG 9(a). In the example of FIG 9(a), for example, if the deformation amount (relative value) of the substrate is "10", the variation amount is only about "+30%" in the detection fixed electrode and the detection movable electrode.

As a such a result that the variation in the relative distance between the detection fixed electrode and the detection movable electrode is small, the variation in the capacitance value configured by the electrode pair formed of the detection fixed electrode and the detection movable electrode is small as shown in FIG 9(b), and the offset variation amount is very small. In the example of FIG. 9(b), for example, if the deformation amount (relative value) of the substrate is "10", the variation amount of the capacitance is only about "-0.2%".

### <Cross-sectional configuration of sensor chip of MEMS acceleration sensor of present embodiment>

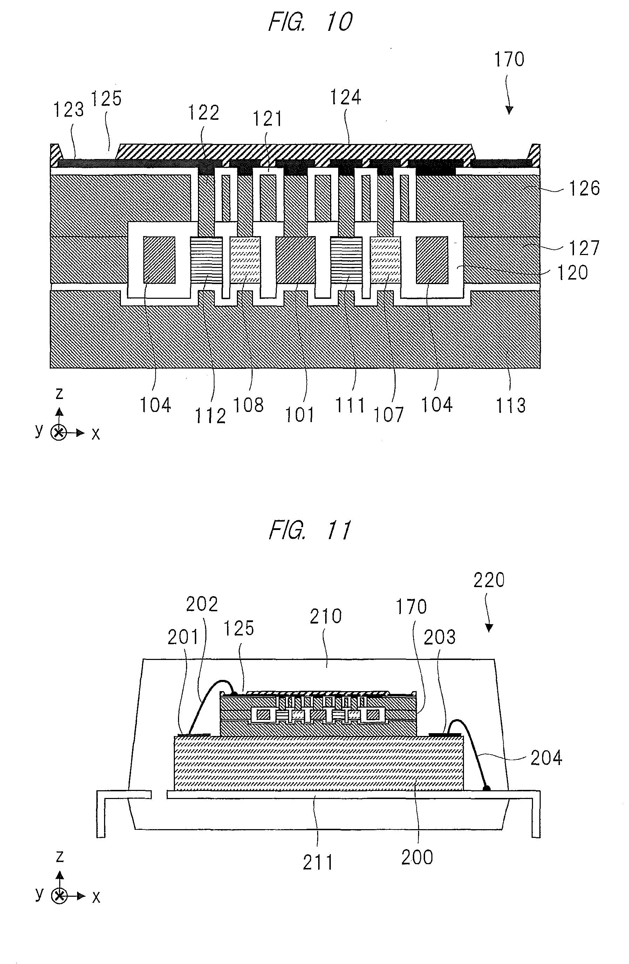

Subsequently, the cross-sectional configuration of the sensor chip of the MEMS acceleration sensor according to the present embodiment will be described by using FIG 10. FIG 10 is a cross-sectional view showing one example of a cross-sectional configuration of the sensor chip of the MEMS acceleration sensor. FIG 10 shows the cross-sectional view of the sensor chip in which the cap substrate and the through electrode are formed in the device layer.

In the sensor chip 170 of the MEMS acceleration sensor according to the present embodiment, the sensor element of the MEMS acceleration sensor is formed in the device layer 127 fixed to the substrate 113. The sensor elements formed in the device layer 127 include: the movable unit 104; the fixed portion 101 that supports the movable unit 104; the fixed portions 107, 108, 111, 112 that support the detection fixed electrodes 106a, 106b, 110a, 110b each forming a pair with the detection movable electrodes 105a, 105b, 109a, 109b formed on the movable unit 104; and others, as described above (FIG 1, etc.). The movable unit 104 of the sensor element is movable in a hollow space 120 of the device layer 127.

A lead-out electrode 122 is an electrode that passes through a cap substrate 126, and is formed by burying the insulating film 121 in the cap substrate 126 to be electrically separated. The cap substrate 126 and the device layer 127 formed with the sensor element are joined to each other, so that the sensor element is protected by the cap substrate 126. At this time, the lead-out electrode 122 and the fixed portion 107, 108, 111, 112 of the respective detection fixed electrode 106a, 106b, 110a, 110b to the substrate 113 are electrically connected to each other. The lead-out electrode 122 is connected to a pad 125 via a patterned conductive film 123. Thus, the electric potentials of the detection fixed electrodes 106a, 106b, 110a, 110b can be led out from the pad 125 through the lead-out electrode 122 and the conductive film 123. At the same time, in the sensor chip 170 of the MEMS acceleration sensor, the surface of the conductive film 123 except for that of the pad 125 is protected by the protective film 124.

### <Cross-sectional configuration of package of MEMS acceleration sensor of present embodiment>

Subsequently, a cross-sectional configuration of the package of the MEMS acceleration sensor according to the present embodiment will be described by using FIG 11. FIG 11 is a cross-sectional view showing one example of a cross-sectional configuration of the package of the MEMS acceleration sensor. FIG 11 shows a cross-sectional view of the package mounted with the sensor chip as a mounting mode of the sensor chip of FIG 10 described above.

In a package 220 of the MEMS acceleration sensor according to the present embodiment, a lead frame 211 is placed inside a package member 210, and a circuit chip 200 is mounted on the lead frame 211. The circuit chip 200 is formed with integrated circuits each formed of a transistor and a passive element (such as a CV conversion circuit 140, a differential detection circuit 145, a demodulation circuit 150, etc. shown in FIG 2 described above). The integrated circuit formed on the circuit chip 200 is a circuit that has a function of signal processing of the output signal outputted from the acceleration sensor element, and that eventually outputs an acceleration signal. A pad 203 formed on the circuit chip 200 is connected to the lead frame 211 and the metal wire 204, and is electrically connected to a terminal connected to outside of the package member 210.

Furthermore, a sensor chip 170 shown in FIG 10 described above is mounted on the circuit chip 200. The sensor chip 170 is formed with a structural body of the MEMS acceleration sensor configuring the acceleration sensor element. A pad 125 formed on the sensor chip 170 and the pad 201 formed on the circuit chip 200 are connected to each other by the metal wire 202.

A package member 210 is made of, for example, resin. The package 220 is formed by setting the circuit chip 200 and the sensor chip 170 mounted on the lead frame 211 into a die, and injecting a resin material melted at a high temperature into the die, and then, cooling and curing them. That is, the package 220 is formed by a transfer mold step.

The transfer mold step has a higher mass productivity than that of the conventional ceramic package step, and therefore, is an effective process for reducing the manufacturing cost of the acceleration sensor. However, the resin which is the configuring material has a feature of volume expansion due to moisture absorption and volume shrink due to drying. When the humidity of the environment where the package 220 is placed varies, the sensor chip 170 placed inside is distorted by the expansion and shrink of the package member 210.

However, in the sensor chip 170 according to the present embodiment, even if the substrate 113 is distorted, the relative distance between the detection movable electrode connected to the movable unit 104 and the detection fixed electrode connected to the substrate 113, which form the acceleration sensor element, is difficult to vary. That is, even if the humidity of the environment where the acceleration sensor is placed varies when the acceleration is not applied, there is a feature that the capacitance value of the capacitor formed of the detection movable electrode and the detection fixed electrode is difficult to vary. That is, even if the humidity of the environment where the acceleration sensor is placed varies, the zero-point offset is difficult to occur.

### <Effects of present embodiment>

According to the MEMS acceleration sensor 100 according to the present embodiment described above, in the configuration including the movable unit 104, the P-side first electrode pair formed of the detection movable electrode 105a and the detection fixed electrode 106a, the P-side second electrode pair formed of the detection movable electrode 105b and the detection fixed electrode 106b, the N-side first electrode pair formed of the detection movable electrode 109a and the detection fixed electrode 110a, and the N-side second electrode pair formed of the detection movable electrode 109b and the detection fixed electrode 110b, the following effects can be obtained by supporting the movable unit 104 at one point of the fixed portion 101 arranged inside the movable unit 104, and arranging the fixed portion 101 of the movable unit 104, the fixed portion 107 of the detection fixed electrode 106a, the fixed portion 108 of the detection fixed electrode 106b, the fixed portion 111 of the detection fixed electrode 110a, and the fixed portion 112 of the detection fixed electrode 110b on the line 116 perpendicular to the detection direction 115 of the MEMS acceleration sensor 100, and besides, providing the P-side first electrode pair and the N-side first electrode pair on one side of the fixed portion 101 of the movable unit 104 and providing the P-side second electrode pair and the N-side second electrode pair on the other side thereof

In other words, as the effects of the present embodiment, the movable unit 104 is robust against the deformation of the detection direction 115 since the movable unit 104 is supported at one point of the fixed portion 101, and besides, the influence of the rotation noises can be mechanically cancelled prior to the LSI circuit including the CV conversion circuit 140 and others since the noises caused by rotation appear with different signs between the P-side first electrode pair (capacitive element CP1) and the P-side second electrode pair (capacitive element CP2) and between the N-side first electrode pair (capacitive element CN1) and the N-side second electrode pair (capacitive element CN2). Thus, robustness can be provided, and the saturation of the amplifier due to the multi-axis sensitivity can be mechanically prevented.

In this manner, according to the present embodiment, the signals caused by the applied acceleration other than the measurement signal are canceled out from each other before the input to the LSI circuit, and the function stop due to the false operation and the false output of the MEMS acceleration sensor can be suppressed. That is, the MEMS acceleration sensor that suppresses the offset variation without the applied acceleration due to the substrate deformation caused by the temperature and the humidity of the environment where the MEMS acceleration sensor is placed can be provided without increasing the manufacturing cost.

More preferably, the following effects can be obtained In the electrode pairs, the P-side first electrode pair and the P-side second electrode pair can be arranged on the one same direction with respect to the line 116 perpendicular to the detection direction 115 passing through the fixed portion 101 of the movable unit 104, and the N-side first electrode pair and the N-side second electrode pair can be arranged on the other same direction. Furthermore, in the electrode pairs, the P-side first electrode pair, the P-side second electrode pair, the N-side first electrode pair and the N-side second electrode pair can be formed in the facing-type parallel plate shapes whose capacitance values are varied by the inter-electrode distance, respectively. Also, in the electrode pairs, each of the P-side first electrode pair, the P-side second electrode pair, the N-side first electrode pair, and the N-side second electrode pair can be set on the inner side of the inner perimeter frame of the frame body configured by the movable unit 104. These effects can achieve a variety of types of variations for the method of setting the electrode pairs, which lead to facilitation of the manufacturing of the acceleration sensor.

### [Second Embodiment]

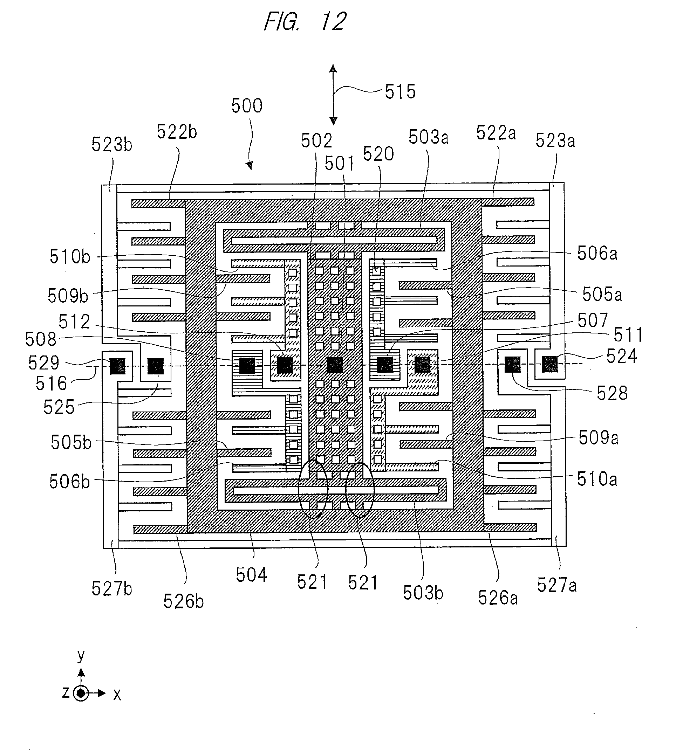

The MEMS acceleration sensor according to the second embodiment will be described by using FIG 12. In the present embodiment, a point different from that of the first embodiment will be mainly described. In the present embodiment, while the explanation is made with a 500 number, components having the numbers of the same last two digits (the digits in the tens place and the ones place) indicate the same members so as to correspond to a 100 number in the first embodiment.

### <Planar configuration of MEMS acceleration sensor>

First, a planar configuration of the MEMS acceleration sensor according to the present embodiment will be described by using FIG 12. FIG 12 is a plan view showing one example of a planar configuration of the MEMS acceleration sensor. FIG 12 is a view of the MEMS acceleration sensor seen from an upper surface.

As a structural body formed on the substrate, the MEMS acceleration sensor 500 according to the present embodiment includes: (P-side) diagnosis movable electrodes 522a, 522b; (P-side) diagnosis fixed electrodes 523a, 523b; a fixed portion 524; a fixed portion 525; (N-side) diagnosis movable electrodes 526a, 526b; (N-side) diagnosis fixed electrodes 527a, 527b; a fixed portion 528; a fixed portion 529; and others, in addition to the configuration similar to that of the first embodiment including: a fixed portion 501; a rigid body 502; beams 503a, 503b; a movable unit 504; (P-side) detection movable electrodes 505a, 505b; (P-side) detection fixed electrodes 506a, 506b; a fixed portion 507; a fixed portion 508; (N-side) detection movable electrodes 509a, 509b; (N-side) detection fixed electrodes 510a, 510b; a fixed portion 511; a fixed portion 512; and others. In the following, the description on the configurations and the effects similar to those of the first embodiment will be mainly omitted, and the configurations and the effects different from those of the first embodiment will be mainly described

### <<Configuration and effect with different component>>

As shown in FIG 12, in the MEMS acceleration sensor 500 according to the present embodiment, the fixed portion 501 is arranged on the substrate, the rigid body 502 extending in the detection axis direction (y direction of FIG. 12) is connected to the fixed portion 501, and the beam 503a and the beam 503b that deform in the detection axis direction are further connected from the rigid body 502. The beam 503a and the beam 503b are connected with the movable unit 504 serving as a proof mass of the MEMS acceleration sensor 500. Each of the beam 503a and the beam 503b is supported at a plurality of points (three points in the example of FIG 12) in portions connected with the rigid body 502 and the movable unit 504 by a plurality of supporting portions 521, and has such a feature that mechanical displacement in other direction than the detection direction (detection axis direction) 515 is difficult to occur. This can lead to enhancement of the rigidity of the beams 503a, 503b in the z direction, which leads to suppression of rotational moment.

The detection movable electrodes 505a, 505b, 509a, 509b integrally formed with the movable unit 504 are formed in the movable unit 504, and the detection fixed electrodes 506a, 506b, 510a, 510b are formed so as to face the detection movable electrodes 505a, 505b, 509a, and 509b, respectively.

The detection movable electrode 505a and the detection fixed electrode 506a, or the detection movable electrode 505b and the detection fixed electrode 506b form the capacitive element. The capacitance of each capacitive element increases when the movable unit 504 is displaced in the plus direction of the y direction by the externally applied acceleration. Furthermore, the detection movable electrode 509a and the detection fixed electrode 510a, or the detection movable electrode 509b and the detection fixed electrode 510b form the capacitive element. The capacitance of each capacitive element decreases when the movable unit 504 is displaced in the plus direction of the y direction by the externally applied acceleration.

An the different point from the first embodiment, a hole 520 is partially formed in a linear component connecting the detection fixed electrodes 506a, 506b, 510a, 510b and the fixed portions 507, 508, 511, 512, so as to reduce mass. Furthermore, the movable unit 504 and the fixed portion 501 are connected to each other, and the hole 520 is partially formed in the rigid body 502 supported by the fixed portion 501 so as to reduce mass. The hole 520 can be partially formed similarly in the movable unit 504 and the components connecting the diagnosis fixed electrodes 523a, 523b, 527a, 527b and the fixed portions 524, 525, 528, 529 so as to reduce mass. By reducing the mass as described above, the natural frequency of the entire component can be set on the high frequency side, and the mechanical response for the input of the high frequency noise can be reduced, and therefore, an acceleration sensor having high reliability can be provided.

### <<Configuration with different PN position and effect>>

The present embodiment is different from the first embodiment in that the detection movable electrode 505a and the detection fixed electrode 506a, or the detection movable electrode 505b and the detection fixed electrode 506b are set in opposite directions from each other across the line 516 perpendicular to the detection direction (detection axis direction) 515 of the acceleration sensor passing through the fixed portion 501 of the movable unit 504. In other words, the P-side first electrode pair formed of the detection movable electrode 505a and the detection fixed electrode 506a is arranged at the upper right position of FIG 12, and the P-side second electrode pair formed of the detection movable electrode 505b and the detection fixed electrode 506b are arranged at the lower left position thereof. These arrangements are point-symmetric with each other across the fixed portion 501.

The present embodiment is different from the first embodiment in that the detection movable electrode 509a and the detection fixed electrode 510a, or the detection movable electrode 509b and the detection fixed electrode 510b are set in opposite directions from each other across the line 516 perpendicular to the detection direction (detection axis direction) 515 of the acceleration sensor passing through the fixed portion 501 of the movable unit 504. In other words, the N-side first electrode pair formed of the detection movable electrode 509a and the detection fixed electrode 510a is arranged at the lower right position of FIG. 12, and the N-side second electrode pair formed of the detection movable electrode 509b and the detection fixed electrode 510b is arranged at the upper left position thereof These arrangements are point-symmetric with each other across the fixed portion 501.

In other words, according to the present embodiment, with respect to the line 516 perpendicular to the detection direction 515 passing through the fixed portion 501 of the movable unit 504, the P-side first electrode pair formed of the detection movable electrode 505a and the detection fixed electrode 506a and the N-side second electrode pair formed of the detection movable electrode 509b and the detection fixed electrode 510b are arranged in a first direction (plus direction of y direction of FIG 12), and the P-side second electrode pair formed of the detection movable electrode 505b and the detection fixed electrode 506b and the N-side first electrode pair formed of the detection movable electrode 509a and the detection fixed electrode 510a are arranged in a second direction (minus direction of y direction of FIG 12) different from the first direction.

That is, the method of setting the electrode pair configured to measure the displacement amount of the movable unit 504 has various types. Also in such methods of setting the electrode pair as similar to the first embodiment, even when the movable unit 504 is displaced by the input of the acceleration other than the externally applied measurement amount, the variation of the capacitance value can be canceled out inside the sensor chip configured with the mechanical element, and therefore, the signal is not inputted to the computation circuit. That is, it is not required to consider a case that the electric signal exceeds a range that the signal can be handled by the LSI circuit, that is, a case that the LSI circuit causes saturation, and therefore, the electric signal does not cause function stop of the acceleration sensor caused when the signal originally to be measured is buried in the saturation signal. That is, by cancelling the signal caused by the applied acceleration other than the measurement signal before the input to the LSI circuit, the function stop caused by the false operation and the false output of the acceleration sensor by the applied acceleration other than the measurement signal can be suppressed.

### <<Additional configuration of diagnosis function and effect>>

In the present embodiment, as an additional configuration of the first embodiment, the diagnosis movable electrodes 522a, 522b, 526a, 526b integrally formed with the movable unit 504 are formed on the movable unit 504 as shown in FIG 12, and the diagnosis fixed electrodes 523a, 523b, 527a, 527b are formed so as to face the diagnosis movable electrodes 522a, 522b, 526a, 526b. Each of a diagnosis P-side first electrode pair formed of the diagnosis movable electrode 522a and the diagnosis fixed electrode 523a, a diagnosis P-side second electrode pair formed of the diagnosis movable electrode 522b and the diagnosis fixed electrode 523b, a diagnosis N-side first electrode pair formed of the diagnosis movable electrode 526a and the diagnosis fixed electrode 527a, or a diagnosis N-side second electrode pair formed of the diagnosis movable electrode 526b and the diagnosis fixed electrode 527b forms a capacitive element.

These diagnosis electrode pairs can be arranged in a line symmetry or a point symmetry as similar to the detection electrode pairs. In other words, in FIG 12, with respect to the line 516 perpendicular to the detection direction 515 passing through the fixed portion 501 of the movable unit 504, the diagnosis P-side first electrode pair and the diagnosis P-side second electrode pair are arranged in the first direction (plus direction of y direction of FIG 12), and the diagnosis N-side first electrode pair and the diagnosis N-side second electrode pair are arranged in the second direction (minus direction of y direction of FIG 12) different from the first direction. The arrangements are not limited to this, and, with respect to the line 516 perpendicular to the detection direction 515 passing through the fixed portion 501 of the movable unit 504, the diagnosis P-side first electrode pair and the diagnosis N-side second electrode pair may be arranged in the first direction (plus direction of y direction of FIG 12), and the diagnosis P-side second electrode pair and the diagnosis N-side first electrode pair may be arranged in the second direction (minus direction of y direction of FIG. 12) different from the first direction.

When a diagnosis signal is applied between the diagnosis movable electrode 522a and the diagnosis fixed electrode 523a and between the diagnosis movable electrode 522b and the diagnosis fixed electrode 523b forming the capacitive elements, an electrostatic force acts between the diagnosis movable electrode 522a and the diagnosis fixed electrode 523a and between the diagnosis movable electrode 522b and the diagnosis fixed electrode 523b, so that the diagnosis movable electrode 522a and the diagnosis movable electrode 522b are displaced in the plus direction of the y direction of FIG 12. When the diagnosis movable electrodes 522a, 522b are displaced in the plus direction of the y direction of FIG 12, the movable unit 504 integrally formed with the diagnosis movable electrodes 522a, 522b is also forced to be displaced in the plus direction of the y direction of FIG. 12.

When a diagnosis signal is applied between the diagnosis movable electrode 526a and the diagnosis fixed electrode 527a and between the diagnosis movable electrode 526b and the diagnosis fixed electrode 527b forming the capacitive elements, an electrostatic force acts between the diagnosis movable electrode 526a and the diagnosis fixed electrode 527a and between the diagnosis movable electrode 526b and the diagnosis fixed electrode 527b, so that the diagnosis movable electrode 526a and the diagnosis movable electrode 526b are displaced in the minus direction of the y direction of FIG. 12. When the diagnosis movable electrodes 526a, 526b are displaced in the minus direction of the y direction of FIG. 12, the movable unit 504 integrally formed with the diagnosis movable electrodes 526a, 526b is also forced to be displaced in the minus direction of the y direction of FIG. 12.

Even when the acceleration is not applied on the movable unit 504, the MEMS acceleration sensor of the present embodiment also has a function of forcibly displacing the movable unit 504. That is, an acceleration sensor having a function of diagnosing the mechanical breakdown of the acceleration sensor by using electrical means and having high reliability can be provided Furthermore, when the diagnosis function is not used, the electrical noise can be shielded by fixing the electric potentials of the diagnosis fixed electrode 523a, 523b and 527a, 527b set in the periphery of the movable unit of the acceleration sensor.

### [Third Embodiment]

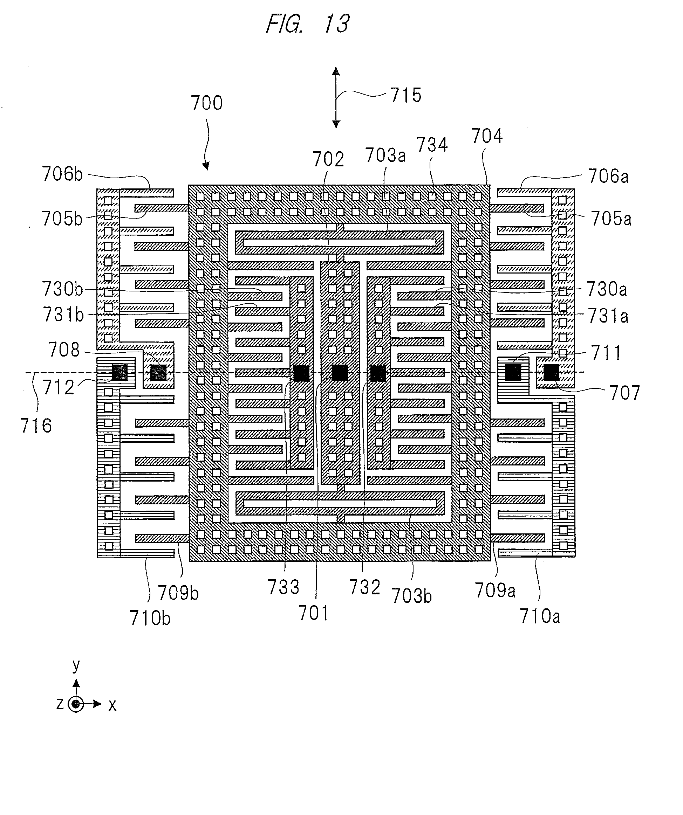

The MEMS acceleration sensor according to the third embodiment will be described by using FIG 13. In the present embodiment, a point different from that of the first embodiment will be mainly described In the present embodiment, while the explanation is made with a 700 number, components having the numbers of the same last two digits (the digits in the tens place and the ones place) indicate the same members so as to correspond to a 100 number in the first embodiment.

### <Planar configuration of MEMS acceleration sensor>

First, a planar configuration of the MEMS acceleration sensor according to the present embodiment will be described by using FIG 13. FIG. 13 is a plan view showing one example of a planar configuration of the MEMS acceleration sensor. FIG 13 is a view of the MEMS acceleration sensor seen from an upper surface.

As a structural body formed on the substrate, the MEMS acceleration sensor 700 according to the present embodiment includes: damper movable electrodes 730a, 730b; damper fixed electrodes 731a, 731b; a fixed portion 732; a fixed portion 733; and others, in addition to the configuration similar to that of the first embodiment including: a fixed portion 701; a rigid body 702; beams 703a, 703b; a movable unit 704; (P-side) detection movable electrodes 705a, 705b; (P-side) detection fixed electrodes 706a, 706b; a fixed portion 707; a fixed portion 708; (N-side) detection movable electrodes 709a, 709b; (N-side) detection fixed electrodes 710a, 710b; a fixed portion 711; a fixed portion 712; and others. In FIG. 13, note that "715" indicates the detection direction (detection axis direction) of the MEMS acceleration sensor 700, and "716" indicates a line perpendicular to the detection direction 715. In the following, the description on the configurations and the effects similar to those of the first embodiment will be mainly omitted, and the configurations and the effects different from those of the first embodiment will be mainly described.

### «Configuration and effect with different component»

As shown in FIG 13, in the MEMS acceleration sensor 700 according to the present embodiment, the fixed portion 701 is arranged on the substrate, the rigid body 702 extending in the detection axis direction (y direction of FIG. 13) is connected to the fixed portion 701, and the beam 703a and the beam 703b that deform in the detection axis direction are further connected from the rigid body 702. The beam 703a and the beam 703b are connected with the movable unit 704 serving as a proof mass of the MEMS acceleration sensor 700.

The detection movable electrodes 705a, 705b, 709a, 709b integrally formed with the movable unit 704 are formed in the movable unit 704, and the detection fixed electrodes 706a, 706b, 710a, 710b are formed so as to face the detection movable electrodes 705a, 705b, 709a, and 709b, respectively.

The detection movable electrode 705a and the detection fixed electrode 706a, or the detection movable electrode 705b and the detection fixed electrode 706b form the capacitive element. The capacitance of each capacitive element increases when the movable unit 704 is displaced in the plus direction of the y direction by the externally applied acceleration. Furthermore, the detection movable electrode 709a and the detection fixed electrode 710a, or the detection movable electrode 709b and the detection fixed electrode710b form the capacitive element. The capacitance of each capacitive element decreases when the movable unit 704 is displaced in the plus direction of the y direction by the externally applied acceleration.

Each of the P-side first electrode pair formed of the detection movable electrode 705a and the detection fixed electrode 706a, the P-side second electrode pair formed of the detection movable electrode 705b and the detection fixed electrode 706b, the N-side first electrode pair formed of the detection movable electrode 709a and the detection fixed electrode 710a, and the N-side second electrode pair formed of the detection movable electrode 709b and the detection fixed electrode 710b is arranged on an outer side of the outer perimeter frame of the frame body of the movable unit 704 as different from the first embodiment.

Further, as the different point from the first embodiment, a hole 734 is partially formed in a linear component connecting the detection fixed electrodes 706a, 706b, 710a, 710b and the fixed portions 707, 708, 711, 712, so as to reduce mass. Furthermore, the hole 734 can be partially formed similarly in the movable unit 704 and the components connecting the damper fixed electrodes 731a, 731b and the fixed portions 732,733 so as to reduce mass. By reducing the mass as described above, the natural frequency of the entire component can be set on the high frequency side, and the mechanical response for the input of the high frequency noise can be reduced, and therefore, an acceleration sensor having high reliability can be provided.

### «Additional configuration of damper function and effect»

Also, in the present embodiment, as an additional configuration of the first embodiment, the damper movable electrodes 730a, 730b integrally formed with the movable unit 704 are formed on the movable unit 704 as shown in FIG. 13, and the damper fixed electrodes 731a, 731b fixed to the substrate are formed so as to face the damper movable electrodes 730a, 730b. Each of a P-side damper first electrode pair formed of the damper movable electrode 730a and the damper fixed electrode 731a and an N-side damper first electrode pair formed of the damper movable electrode 730b and a damper fixed electrode 731b configures a damper function. The damper function is provided on the inner side of the inner perimeter frame of the frame body of the movable unit 704.

When the movable unit 704 is displaced, the gas in the space between the damper movable electrode 730a and the damper fixed electrode 731a and between the damper movable electrode 730b and the damper fixed electrode 731b is compressed and expanded, and therefore, the damper configured by the damper movable electrodes 730a, 730b and the damper fixed electrodes 731a and 731b has a function of damping the displacement of the movable unit 704. The function of damping the displacement has an effect proportional to a velocity of the movable unit 704, and therefore, the damping performance is higher as the frequency of displacement is in the higher frequency band. Therefore, the acceleration sensor having the damper function has a feature of mechanical response to the acceleration in the low frequency band but no mechanical response to the acceleration in the high frequency band. That is, the acceleration sensor has such a feature that the frequency band of the acceleration to be measured can be adjusted by the MEMS structure. That is, the mechanical response for the input of the high frequency noise can be reduced, and therefore, the acceleration sensor having the higher reliability can be provided.

The above-described damper fixed electrodes 731a, 731b may be electrically connected via the fixed portions 732, 733, respectively, so as to apply an electric potential. By applying an electric potential different from that of the movable unit 704 as this electric potential, such an "electrostatic spring softening" that the natural frequency of the machine component configured by the movable unit 704 and the beams 703a, 703b that deform in the detection direction is effectively small can be obtained. The manufacturing yield can be increased in the manufacturing step because of the beam structure that is difficult to deform, and the function of adjustment to the desired natural frequency can be provided by applying the electric potential to the damper fixed electrodes 731a, 731b electrically connected via the fixed portions 732, 733 when the acceleration sensor is actually used for measurement. That is, a technique capable of inexpensively manufacturing the acceleration sensor can be provided.

In the foregoing, the invention made by the present inventors has been concretely described based on the embodiments. However, it is needless to say that the present invention is not limited to the foregoing embodiments and various modifications and alterations can be made within the scope of the present invention. For example, the above-described first to third embodiments have been explained in detail for easily understanding the present invention, but are not always limited to the ones including all structures explained above. Also, a part of the structure of one embodiment can be replaced with the structure of the other embodiment, and besides, the structure of the other embodiment can be added to the structure of one embodiment. Further, the other structure can be added to/eliminated from/replaced with a part of the structure of each embodiment.

### REFERENCE EXPLANATION

- 100: MEMS acceleration sensor
- 101: fixed portions
- 102: rigid body
- 103a, 103b: beam
- 104: movable unit
- 105a, 105b: (P-side) detection movable electrode
- 106a, 106b: (P-side) detection fixed electrode
- 107: fixed portion
- 108: fixed portion
- 109a, 109b: (N-side) detection movable electrode
- 110a, 110b: (N-side) detection fixed electrode
- 111: fixed portion
- 112: fixed portion
- 113: substrate
- 115: detection direction
- 116: line perpendicular to detection direction
- 120: hollow space
- 121: insulation film
- 122: lead-out electrode
- 123: conductive film
- 124: protective film
- 125: pad
- 126: cap substrate
- 127: device layer
- 130: carrier wave applying circuit
- 140: CV conversion circuit
- 141: operational amplifier
- 142: operational amplifier
- 143: detection signal
- 144: detection signal
- 145: differential detection circuit
- 146: electric potential difference signal
- 150: demodulation circuit
- 160: output terminal
- 170: sensor chip
- 200: circuit chirp
- 201: pad
- 202: metal wire
- 203: pad
- 204: metal wire
- 210: package member
- 211: lead frame
- 220: package
- 300: MEMS acceleration sensor (conventional technique)
- 301a, 301b: fixed portion
- 303a, 303b: beam
- 304: movable unit
- 305a, 305b: (P-side) detection movable electrode
- 306a, 306b: (P-side) detection fixed electrode
- 307: fixed portion
- 308: fixed portion
- 309a, 309b: (N-side) detection movable electrode
- 310a, 310b: (N-side) detection fixed electrode
- 311: fixed portion
- 312: fixed portion
- 313: substrate
- 315: detection direction
- 500: MEMS acceleration sensor
- 501: fixed portion
- 502: rigid body
- 503a, 503b: beam
- 504: movable unit
- 505a, 505b: (P-side) detection movable electrode
- 506a, 506b: (P-side) detection fixed electrode
- 507: fixed portion
- 508: fixed portion
- 509a, 509b: (N-side) detection movable electrode
- 510a, 510b: (N-side) detection fixed electrode
- 511: fixed portions
- 512: fixed portions
- 515: detection direction
- 516: line perpendicular to detection direction
- 520: hole
- 521: supporting portion
- 522a, 522b: (P-side) diagnosis movable electrode
- 523a, 523b: (P-side) diagnosis fixed electrode
- 524: fixed portion
- 525: fixed portion
- 526a, 526b: (N-side) diagnosis movable electrode
- 527a, 527b: (N-side) diagnosis fixed electrode
- 528: fixed portion
- 529: fixed portion
- 700: MEMS acceleration sensor
- 701: fixed portion
- 702: rigid body
- 703a, 703b: beam
- 704: movable unit
- 705a, 705b: (P-side) detection movable electrode
- 706a, 706b: (P-side) detection fixed electrode
- 707: fixed portion
- 708: fixed portion
- 709a, 709b: (N-side) detection movable electrode
- 710a, 710b: (N-side) detection fixed electrode
- 711: fixed portion
- 712: fixed portion
- 715: detection direction
- 716: line perpendicular to detection direction
- 730a, 730b: damper movable electrode
- 731a, 731b: damper fixed electrode
- 732: fixed portion
- 733: fixed portion
- 734: hole

## Claims

1. An electrostatic-capacitance inertial sensor comprising:
a movable unit;
a positive direction first electrode pair whose capacitance value is increased by displacement of the movable unit in a positive direction of a detection axis;
a positive direction second electrode pair whose capacitance value is increased by the displacement of the movable unit in the positive direction of the detection axis;
a negative direction first electrode pair whose capacitance value is decreased by displacement of the movable unit in the positive direction of the detection axis; and
a negative direction second electrode pair whose capacitance value is decreased by the displacement of the movable unit in the positive direction of the detection axis,
wherein the movable unit is supported at one point of a fixed portion arranged on an inner side of the movable unit,
a fixed portion of the movable unit, a fixed portion of the positive direction first electrode pair, a fixed portion of the positive direction second electrode pair, a fixed portion of the negative direction first electrode pair, and a fixed portion of the negative direction second electrode pair are arranged on a line perpendicular to a detection direction of the inertial sensor, and
the positive direction first electrode pair and the negative direction first electrode pair are arranged on one side of the fixed portion of the movable unit, and the positive direction second electrode pair and the negative direction second electrode pair are arranged on the other side of the fixed portion of the movable unit.

2. The inertial sensor according to claim 1,
wherein the positive direction first electrode pair and the positive direction second electrode pair are arranged in a first direction with respect to a line perpendicular to the detection direction passing through the fixed portion of the movable unit, and
the negative direction first electrode pair and the negative direction second electrode pair are arranged in a second direction different from the first direction with respect to the line perpendicular to the detection direction passing through the fixed portion of the movable unit.

3. The inertial sensor according to claim 1,
wherein the positive direction first electrode pair and the negative direction second electrode pair are arranged in a first direction with respect to a line perpendicular to a detection direction passing through the fixed portion of the movable unit, and
the positive direction second electrode pair and the negative direction first electrode pair are arranged in a second direction different from the first direction with respect to the line perpendicular to the detection direction passing through the fixed portion of the movable unit.

4. The inertial sensor according to claim 1,
wherein the positive direction first electrode pair, the positive direction second electrode pair, the negative direction first electrode pair, the negative direction second electrode pair are formed in facing-type parallel plate shapes whose capacitance values are varied by an inter-electrode distance, respectively.

5. The inertial sensor according to claim 1,
wherein each of the positive direction first electrode pair, the positive direction second electrode pair, the negative direction first electrode pair, the negative direction second electrode pair is set on an inner side of an inner perimeter frame of a frame body configured by the movable unit.

6. The inertial sensor according to claim 1,
wherein each of the positive direction first electrode pair, the positive direction second electrode pair, the negative direction first electrode pair, the negative direction second electrode pair is set on an outer side of an outer perimeter frame of a frame body configured by the movable unit.

7. The inertial sensor according to claim 1, further comprising:
a plurality of diagnosis electrode pairs that forcibly displace the movable unit by applying of a diagnosis signal to diagnose a mechanical breakdown of the inertial sensor,
wherein the plurality of diagnosis electrode pairs include:
a diagnosis positive direction first electrode pair that is displaced in a positive direction of the detection axis of the movable unit by the applied diagnosis signal;
a diagnosis positive direction second electrode pair that is displaced in the positive direction of the detection axis of the movable unit by the applied diagnosis signal;
a diagnosis negative direction first electrode pair that is displaced in a negative direction of the detection axis of the movable unit by the applied diagnosis signal; and
a diagnosis negative direction second electrode pair that is displaced in the negative direction of the detection axis of the movable unit by the applied diagnosis signal,
a fixed portion of the diagnosis positive direction first electrode pair, a fixed portion of the diagnosis positive direction second electrode pair, a fixed portion of the diagnosis negative direction first electrode pair, and a fixed portion of the diagnosis negative direction second electrode pair are arranged on the line perpendicular to the detection direction of the inertial sensor, and
the diagnosis positive direction first electrode pair and the diagnosis negative direction first electrode pair are arranged on one side of the fixed portion of the movable unit, and the diagnosis positive direction second electrode pair and the diagnosis negative direction second electrode pair are arranged on the other side of the fixed portion of the movable unit.

8. The inertial sensor according to claim 7,
wherein the diagnosis positive direction first electrode pair and the diagnosis positive direction second electrode pair are arranged in a first direction with respect to the line perpendicular to the detection direction passing through the fixed portion of the movable unit, and
the diagnosis negative direction first electrode pair and the diagnosis negative direction second electrode pair are arranged in a second direction different from the first direction with respect to the line perpendicular to the detection direction passing through the fixed portion of the movable unit.

9. The inertial sensor according to claim 7,
wherein the diagnosis positive direction first electrode pair and the diagnosis negative direction second electrode pair are arranged in a first direction with respect to the line perpendicular to the detection direction passing through the fixed portion of the movable unit, and
the diagnosis positive direction second electrode pair and the diagnosis negative direction first electrode pair are arranged in a second direction different from the first direction with respect to the line perpendicular to the detection direction passing through the fixed portion of the movable unit.

10. The inertial sensor according to claim 1, further comprising:
a plurality of damper electrode pairs that inhibit a displacement of the movable unit,
wherein the plurality of damper electrode pairs include:
a damper positive direction first electrode pair that inhibits a displacement of the movable unit in a positive direction of a detection axis; and
a damper negative direction first electrode pair that inhibits a displacement of the movable unit in a negative direction of the detection axis,
a fixed portion of the damper positive direction first electrode pair and a fixed portion of the damper negative direction first electrode pair are arranged on a line perpendicular to the detection direction of the inertial sensor, and
the damper positive direction first electrode pair is arranged on one side of the fixed portion of the movable unit, and the damper negative direction first electrode pair is arranged on the other side of the fixed portion of the movable unit.

11. The inertial sensor according to claim 10,
wherein a first electric potential is applied to the damper positive direction first electrode pair and the damper negative direction first electrode pair, and a second electric potential different from the first electric potential is applied to the movable unit.

12. The inertial sensor according to claim 1,
wherein holes are formed in at least one of a connecting portion between the positive direction first electrode pair and a fixed portion of the positive direction first electrode pair, a connecting portion between the positive direction second electrode pair and a fixed portion of the positive direction second electrode pair, a connecting portion between the negative direction first electrode pair and a fixed portion of the negative direction first electrode pair, a connecting portion between the negative direction second electrode pair and a fixed portion of the negative direction second electrode pair, and a connecting portion between the movable unit and a fixed portion of the movable unit.

13. The inertial sensor according to claim 7,
wherein a hole is formed in at least one of a connecting portion between the diagnosis positive direction first electrode pair and a fixed portion of the diagnosis positive direction first electrode pair, a connecting portion between the diagnosis positive direction second electrode pair and a fixed portion of the diagnosis positive direction second electrode pair, a connecting portion between the diagnosis negative direction first electrode pair and a fixed portion of the diagnosis negative direction first electrode pair, and a connecting portion between the diagnosis negative direction second electrode pair and a fixed portion of the diagnosis negative direction second electrode pair.

14. The inertial sensor according to claim 10,
wherein a hole is formed in at least one of a connecting portion between the damper positive direction first electrode pair and a fixed portion of the damper positive direction first electrode pair, and a connecting portion between the damper negative direction first electrode pair and a fixed portion of the damper negative direction first electrode pair.
